(19) **Europäisches Patentamt**

**European Patent Office**

**Office européen des brevets**

(11) **EP 1 076 243 A2**

# EUROPEAN PATENT APPLICATION

(12)

(43) Date of publication:
**14.02.2001 Bulletin 2001/07**

(51) Int. Cl.$^7$: **G01R 33/06**, H01L 43/00

(21) Application number: **00306330.2**

(22) Date of filing: **25.07.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **09.08.1999 JP 22516699**
**01.06.2000 JP 2000164042**

(71) Applicant:
**ALPS ELECTRIC CO., LTD.**
**Ota-ku Tokyo 145 (JP)**

(72) Inventors:
• **Nakabayashi, Ryou ,**
c/o Alps Electric Co., Ltd
**Tokyo 145 (JP)**
• **Naito, Yutaka,**
c/o Alps Electric Co., Ltd
**Tokyo 145 (JP)**
• **Hatanai, Takashi,**
c/o Alps Electric Co., Ltd
**Tokyo 145 (JP)**

(74) Representative:
**Kensett, John Hinton**
**Saunders & Dolleymore,**
**9 Rickmansworth Road**
**Watford, Hertfordshire WD18 0JU (GB)**

(54) **Magneto-impedance effect element and method of manufacturing the same**

(57)     A magneto-impedance effect element (M) includes an electrode (3) for supplying a driving AC current, and a magnetic field sensing portion (2) formed by using a soft magnetic thin film or ribbon, wherein the ratio of the element width to the element length of the magnetic field sensing portion, i.e. the aspect ratio W/L, is set to 0.1 or less so that the magnetic field sensitivity to an external magnetic field can be improved, and the magnitude of a necessary bias magnetic field can be decreased.

## FIG. 1

EP 1 076 243 A2

## Description

The present invention relates to a magneto-impedance effect element used as a magnetic field sensor, and particularly to a magneto-impedance effect element having high magnetic field sensitivity even with a low bias magnetic field.

There has recently been demand for a smaller magnetic field sensor having higher sensitivity and responsiveness (high frequency operation) than conventional magnetic flux sensing types with rapid developments in information equipment, measuring equipment, control equipment, etc. Therefore, an element (magneto-impedance effect element) having a magneto-impedance effect has attracted attention.

When a low high-frequency current is supplied to a magnetic field sensing portion comprising a wire-shaped soft magnetic material, an output voltage is produced due to impedance between both ends of the magnetic field sensing portion. The magneto-impedance effect means that when an external magnetic field is applied to the magnetic field sensing portion comprising a soft magnetic material with the low high-frequency current supplied thereto, the impedance of the magnetic field sensing portion sensitively changes to cause a change in output voltage.

The magneto-impedance effect element means an element capable of sensing the magnitude and direction of an external magnetic field by using the magneto-impedance effect.

The change in impedance of the magnetic field sensing portion comprising a soft magnetic material with the application of the external magnetic field is known to be due to the fact that when an AC current is supplied to the magnetic material, the "skin effect" of the AC current liable to flow near the surface changes with the external magnetic field.

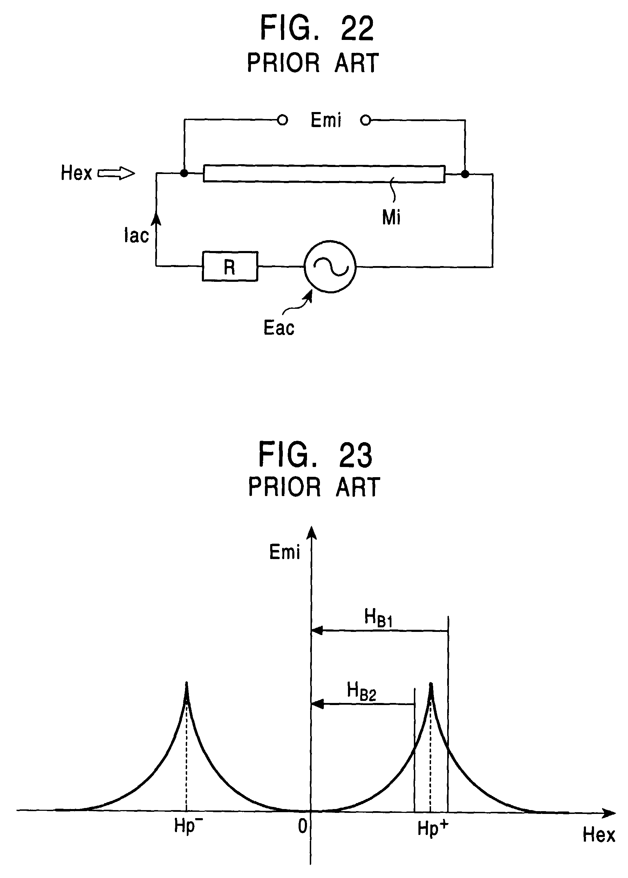

More specifically, the magneto-impedance effect means the phenomenon that in the closed circuit shown in Fig. 22, when an external magnetic field Hex is applied to a wire-shaped magnetic field sensing portion Mi in the direction of the element length with an AC current Iac in the MHz band supplied from a power source Eac, an output voltage Emi is produced between both ends of the magnetic field sensing portion Mi due to the impedance peculiar to the material, and the amplitude of the output voltage Emi changes in the range of several tens % according to the strength of the external magnetic field Hex, i.e., the impedance changes.

The magneto-impedance effect element has the properties that a weak magnetic field sensor having high resolution of about $8.0 \times 10^{-4}$ A/m can be obtained, and that since excitation of several MHz or more is possible, high-frequency excitation of several hundreds MHz can be freely used as a carrier for amplitude modulation, and the cut-off frequency can easily be set to 10 MHz or more in use as a magnetic field sensor, and that the power consumption can be decreased to 10 mW or less.

As the magnetic field sensing portion of the magneto-impedance effect element, an amorphous wire is initially used. Although the amorphous wire material is excellent in productivity as material, it has many undesirable properties for application to a magnetic field sensor.

For example, the amorphous wire material has problems in that in using a circular tip of several tens μm or less for a recording medium at a recording wavelength of several μm or less, a magnetic flux cannot be absorbed by the element due to a shape loss of the tip, in that it is difficult to form an electrode portion for connecting a wiring material for flowing an AC current, in that the wire having a diameter of several tens μm is difficult to align the element, and in that the amorphous wire is readily broken.

Therefore, in order to solve the problems, a magneto-impedance effect element comprising a magnetic field sensing portion comprising a soft magnetic thin film or a soft magnetic ribbon has been proposed for permitting the formation of the magnetic field sensing portion having any desired width and length.

However, when the shape of the magnetic field sensing portion of the magneto-impedance effect element is changed from the wire to the thin film or ribbon, magnetic properties such as the magnetic domain structure are changed to change the properties of the magneto-impedance effect.

For example, in the magneto-impedance effect element comprising the magnetic field sensing portion comprising a soft magnetic thin film, the magnetic field sensitivity is decreased to one tenth of that of the wire-shaped magnetic field sensing portion.

In addition, a conventional magneto-impedance effect element requires the application of a relatively large bias magnetic field to the magnetic field sensing portion.

Fig. 23 is a graph showing the property of the magneto-impedance effect of a conventional magneto-impedance effect element.

The circuit shown in Fig. 22 comprises a conventional magneto-impedance effect element. In the circuit, an external magnetic field Hex is applied to the magneto-impedance effect element Mi in the direction of the element length with a driving AC current Iac supplied from a driving AC source Eac. The output voltage Emi is measured with changing external magnetic fields Hex to obtain such a graph as shown in Fig. 23.

The graph of Fig. 23 showing the property of the magneto-impedance effect shows a bimodal shape having peaks of the output voltage Emi with the external magnetic fields Hex of magnitudes $Hp_+$ and $Hp_-$. The absolute values of $Hp_+$ and $Hp_-$ are substantially the same.

Fig. 23 indicates that the rate of change in the output voltage Emi increases as the magnitude of the external magnetic field Hex approaches $Hp_+$ or $Hp_-$.

Namely, the sensitivity to the external magnetic field Hex is high with the external magnetic field Hex of magnitude close to Hp$_+$ or Hp$_-$. On the other hand, with the external magnetic field Hex of magnitude close to 0, the rate of change in the output voltage Emi is low, and the sensitivity to the external magnetic field Hex is low.

Therefore, in use of the magneto-impedance effect element as a magnetic field sensor, in order to improve the sensitivity to the external magnetic field Hex with the external magnetic field Hex of near zero, for example, a bias magnetic field of magnitude of H$_{B1}$ or H$_{B2}$ is applied to the magnetic field sensing portion in the direction of the element length to shift a graph showing the property of the magneto-impedance effect in the direction of the external magnetic field Hx axis so that a portion with a high rate of change in output voltage lies on the axis of external magnetic field Hex = 0.

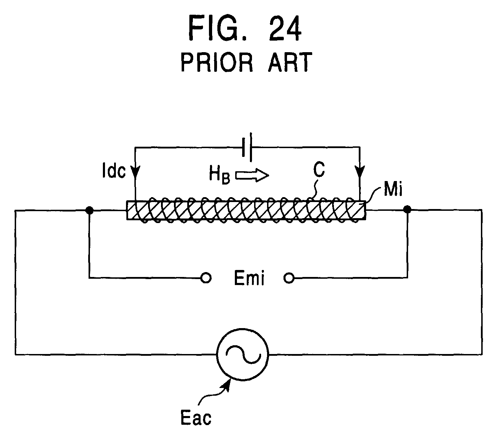

A method of applying the bias magnetic field to the magnetic field sensing portion comprises winding a coil C around the magnetic field sensing portion Mi with an appropriate number of turns, and passing a DC current Idc through the coil to produce a bias magnetic field H$_B$ to be applied to the magnetic field sensing portion Mi in the direction of the element length, as shown in Fig. 24.

In the conventional magneto-impedance effect element, the magnitude Hp$_+$ or Hp$_-$ is about 400 to 480 (A/m). In this case, in order to improve the sensitivity to the external magnetic field Hex with the external magnetic field Hex of near 0, the magnitude of the bias magnetic field H$_B$ applied to the magnetic field sensing portion Mi in the direction of the element length is, for example, H$_{B1}$ = 480 to 560 (A/m). Where the bias magnetic field H$_B$ of magnitude of as high as 480 to 560 (A/m) is required, the number of turns of the coil C is increased to complicate the process. The magnetic field sensing portion Mi has a small size of several mm in length and several hundreds μm in width, and thus the step of winding the coil C around the small magnetic field sensing portion is particularly complicated.

An increase in the number of turns of the coil C causes the problem of increasing the size of the magneto-impedance effect element. There is thus the problem of interfering with miniaturization necessary for application of the magneto-impedance effect element to a magnetic head or a weak magnetic field sensor.

Furthermore, the DC current Idc supplied to the coil C for producing the bias magnetic field HB must be increased, thereby causing the problem of interfering with power saving of the magneto-impedance effect element.

The present invention has been achieved for solving the above problems, and an object of the present invention is to provide a magneto-impedance effect element which has high sensitivity to a magnetic field and thus permits a decrease in magnitude of the bias magnetic field applied even when a magnetic field sensing portion comprises a thin film or ribbon, thereby easily achieving miniaturization and power saving. Another object of the present invention is to provide a method of manufacturing the magneto-impedance effect element.

In order to achieve the objects, the present invention provides a magneto-impedance effect element comprising a magnetic field sensing portion comprising a soft magnetic thin film or ribbon having the magneto-impedance effect, and an electrode for supplying a driving AC current to the magnetic field sensing portion, wherein when an external magnetic field is applied to the magnetic field sensing portion in the direction of the element length with the driving AC current supplied to the magnetic field sensing portion, the absolute value of the magnitude of the external magnetic field producing the maximum output voltage between both ends of the magnetic field sensing portion is 400 (A/m) or less.

Advantageously, when an external magnetic field is applied to the magnetic field sensing portion in the direction of the element length with the driving AC current supplied to the magnetic field sensing portion, the absolute value of the magnitude of the external magnetic field producing the maximum output voltage between both ends of the magnetic field sensing portion can be decreased.

As described above, when the external magnetic field applied to the magnetic field sensing portion in the direction of the element length with the driving AC current supplied to the magnetic field sensing portion is changed in magnitude, the rate of change in the output voltage produced from the magnetic field sensing portion is maximum at the maximum output voltage. Therefore, when the absolute value of the magnitude of the external magnetic field producing the maximum output voltage from the magnetic field sensing portion is decreased, the rate of change in the output voltage is high with the external magnetic field of magnitude close to zero. Therefore, the bias magnetic field applied to the magnetic field sensing portion can be decreased in magnitude.

Particularly, when the absolute value of the magnitude of the external magnetic field producing the maximum output voltage from the magnetic field sensing portion is 400 (A/M) or less, a magnetic field produced from a magnetic member comprising a magnetic material formed in the periphery of the magneto-impedance effect element or laminated on the magneto-impedance effect element can be used as the bias magnetic field.

Even when the bias magnetic field is applied by a coil wound around the magnetic field sensing portion, the number of turns of the coil can be decreased to simplify the process for manufacturing the magnetic field sensing portion.

In application to a magnetic head or a weak magnetic field sensor, the magneto-impedance effect element can also be decreased in size.

The DC current supplied to the coil for producing the bias magnetic field can also be decreased, thereby easily achieving power saving of the magneto-impedance effect element.

Although the magnetic field sensing portion is generally formed in a substantially rectangular shape or linear shape, the portion may be formed in a U shape or zigzag shape. In this case, the direction of the element length coincides with the extension direction of the longest linear portion of the magnetic field sensing portion, i.e., the direction perpendicular to the excitation direction of the magnetic field produced by the driving AC current.

In addition, the absolute value of the magnitude of the external magnetic field producing the maximum output voltage between both ends of the magnetic field sensing portion is preferably 320 (A/m) or less, more preferably 160 (A/m) or less.

In the magneto-impedance effect element in which the absolute value of the magnitude of the external magnetic field producing the maximum output voltage between both ends of the magnetic field sensing portion is in the above range, the soft magnetic thin film or ribbon which constitutes the magnetic field sensing portion preferably has a single domain structure or multi-domain structure. In comparison between the magnetic moment component of in the direction of the element length and the magnetic moment component in the direction of the element width in each of the domains, the total area of domains in which the component in the direction of the element length is larger than that in the direction of the element width is preferably equal to or larger than the total area of domains in which the component in the direction of the element width is larger than that in the direction of the element length.

Particularly, in the magneto-impedance effect element in which the absolute value of the magnitude of the external magnetic field producing the maximum output voltage between both ends of the magnetic field sensing portion is in the above range, the ratio (aspect ratio) W/L of the element width W to the element length L of the magnetic field sensing portion is preferably 0.1 or less.

In the U-shaped or zigzag-shaped magnetic field sensing portion, the total length of portions of the magnetic field sensing portion, which extend in the direction of the element length, is the element length L. In this case, the direction of the element length coincides with the extension direction of the longest linear portion of the magnetic field sensing portion, i.e., the direction perpendicular to the excitation direction of the magnetic field produced by the driving AC current.

In another aspect of the present invention, a magneto-impedance effect element comprises a magnetic field sensing portion comprising a soft magnetic thin film or ribbon having the magneto-impedance effect, and an electrode for supplying a driving AC current to the magnetic field sensing portion, wherein the soft magnetic thin film or ribbon, which constitutes the magnetic field sensing portion, has a single domain structure or multi-domain structure, and in comparison of the magnetic moment component in the direction of the element length to the magnetic moment component in the direction of the element width in each domain, the total area of domains in which the component in the direction of the element length is larger than that in the direction of the element width is equal to the total area of domains in which the component in the direction of the element width is larger than that in the direction of the element length.

Advantageously, the soft magnetic thin film or ribbon has a single domain structure or multi-domain structure, and in comparison of the magnetic moment component in the direction of the element length to the magnetic moment component in the direction of the element width in each domain, the total area of domains in which the component in the direction of the element length is larger than that in the direction of the element width is equal to the total area of domains in which the component in the direction of the element width is larger than that in the direction of the element length. Therefore, the direction of magnetic anisotropy of the soft magnetic thin film or ribbon is substantially isotropic as a whole.

Namely, the magnetic moment of the soft magnetic thin film or ribbon is little fixed in one direction so that in exciting the magnetic field sensing portion comprising the soft magnetic thin film or ribbon by the AC current, the direction of the magnetic moment of the soft magnetic thin film or ribbon can easily be changed. Namely, the magnetic permeability $\mu$ of the soft magnetic thin film or ribbon in the direction of the element width is increased, and with no external magnetic field applied, the magnetic permeability $\mu$ of the soft magnetic thin film or ribbon in the direction the element width is maximum. When the magnetic permeability $\mu$ of the soft magnetic thin film or ribbon in the direction the element width is a maximum value, the magnitude Z of the impedance of the soft magnetic thin film or ribbon is maximum, and the output voltage produced between both ends of the magnetic field sensing portion is also maximum. In other words, the absolute value of the magnitude of the external magnetic field producing the maximum output voltage between both ends of the magnetic field sensing portion is close to zero.

In a further aspect of the present invention, a magneto-impedance effect element comprises a magnetic field sensing portion comprising a soft magnetic thin film or ribbon having the magneto-impedance effect, and an electrode for supplying a driving AC current to the magnetic field sensing portion, wherein the soft magnetic thin film or ribbon, which constitutes the magnetic field sensing portion, has a single domain structure or multi-domain structure, and in comparison of the magnetic moment component in the direction of the element length to the magnetic moment component in the direction of the element width in each domain, the total area of domains in which the component in the direction of the element length is larger than that in the direction of the element width is larger than the total area of domains in which the component in the direction of the element width is larger than that in the direction of the element length.

Even in the case wherein in comparison of the magnetic moment component in the direction of the element length to the magnetic moment component in the direction of the element width in each domain of the soft magnetic thin film or ribbon, the total area of domains in which the component in the direction of the element length is larger than that in the direction of the element width is larger than the total area of domains in which the component in the direction of the element width is larger than that in the direction of the element length, the direction of magnetic anisotropy of the soft magnetic thin film or ribbon, which constitutes the magnetic field sensing portion, can be brought into a near isotropic state as a whole. Therefore, the attained magnetic field sensitivity is equivalent to the magneto-impedance effect element comprising the magnetic field sensing portion having a magnetic domain structure in which the total area of domains in which the component in the direction of the element length is larger than that in the direction of the element width is equal to the total area of domains in which the component in the direction of the element width is larger than that in the direction of the element length,

When the direction of magnetic anisotropy of the soft magnetic thin film or ribbon, which constitutes the magnetic field sensing portion, is in a near isotropic state as a whole, the direction of magnetic anisotropy of the soft magnetic thin film or ribbon can be brought into a substantially isotropic state as a whole by applying only a small external magnetic field to the magnetic field sensing portion in the direction of the element length. Also, the magnetic permeability $\mu$ of the magnetic sensing portion in the direction of the element width can be maximized, and the output voltage produced between both ends of the magnetic field sensing portion can be maximized. Namely, the absolute value of the magnitude of the external magnetic field applied to maximize the output voltage produced between both ends of the magnetic field sensing portion can be decreased.

Although the magnetic field sensing portion is generally formed in a substantially rectangular shape or linear shape, the portion may be formed in a U shape or zigzag shape. In this case, the direction of the element length coincides with the extension direction of the longest linear portion of the magnetic field sensing portion, i.e., the direction perpendicular to the excitation direction of the magnetic field produced by the driving AC current.

In the magneto-impedance effect element comprising the soft magnetic thin film or ribbon having the above-described domain structure, when the external magnetic field is applied to the magnetic field sensing portion in the direction of the element length with the driving AC current supplied to the magnetic field sensing portion, the absolute value of the magnitude of the external magnetic field applied to produce the maximum output voltage between both ends of the magnetic field sensing portion is preferably 400 (A/m) or less.

In the magneto-impedance effect element comprising the soft magnetic thin film or ribbon having the above domain structure, the ratio (aspect ratio) W/L of the element width W to the element length L of the magnetic field sensing portion is preferably 0.1 or less.

In a further aspect of the present invention, a magneto-impedance effect element comprises a magnetic field sensing portion comprising a soft magnetic thin film or ribbon having the magneto-impedance effect, and an electrode portion for supplying a driving AC current to the magnetic field sensing portion, wherein the ratio (aspect ratio) W/L of the element width W to the element length L of the magnetic field sensing portion is preferably 0.1 or less.

Advantageously, it was found that in forming the magnetic field sensing portion of the magneto-impedance effect element, the magnetic field sensitivity of the magneto-impedance effect element can be improved by decreasing the ratio (aspect ratio) W/L of the element width W to the element length L of the magnetic field sensing portion. Particularly, it was found that with an aspect ratio of 0.1 or less, the magnetic field sensitivity of the magneto-impedance effect element is significantly improved.

Since the magnetic field sensing portion is excited by a high-frequency AC current, the strong skin effect is exhibited. At the same time, the element width W, the element length L, resistivity $\rho$, excitation frequency $\omega$, and magnetic permeability $\mu$ in the direction of the element width of the magnetic field sensing portion have the relation to the magnitude $|Z|$ of impedance of the magnetic field sensing portion represented by the following equation 1:

$$|Z| = \left(\frac{L\sqrt{\rho\omega}}{2W}\right)\sqrt{\mu} \qquad \text{Equation 1}$$

Equation 1 indicates that with the element width W, the element length L, resistivity $\rho$, and excitation frequency $\omega$ of the magnetic field sensing portion kept constant, the magnitude $|Z|$ of the impedance of the magnetic field sensing portion is proportional to the one second power of magnetic permeability $\mu$ in the direction of the element width. When the external magnetic field is applied to the magnetic field sensing portion in the direction of the element length with the AC current supplied to the magnetic field sensing portion in the direction of the element length to excite it in the direction of the element width, the magnetic permeability $\mu$ of the magnetic field sensing portion in the direction of the element width is changed to change the magnitude |Z| of the impedance of the magnetic field sensing portion. The change in the magnitude |Z| of the impedance of the magnetic field sensing portion is measured to detect the external magnetic field applied to the magnetic field sensing portion.

The rate of change in the magnitude |Z| of the impedance of the magnetic field sensing portion with changes in the magnetic permeability μ in the direction of the element width increases as the aspect ratio W/L decreases. Namely, the change in magnitude of the output voltage produced between both ends of the magnetic field sensing portion is increased to improve the magnetic field sensitivity of the magneto-impedance effect element.

The ratio (aspect ratio) of the element width W to the element length L of the magnetic field sensing portion is preferably 0.05 or less, and more preferably 0.03 or less.

In the U-shaped or zigzag-shaped magnetic field sensing portion, the total length of portions of the magnetic field sensing portion, which extend in the direction of the element length, is the element length L. In this case, the direction of the element length coincides with the extension direction of the longest linear portion of the magnetic field sensing portion, i.e., the direction perpendicular to the excitation direction of the magnetic field produced by the driving AC current.

In the magneto-impedance effect element comprising the magnetic field sensing portion having the above aspect ratio, the soft magnetic thin film or ribbon, which constitutes the magnetic field sensing portion, has a single domain structure or multi-domain structure, and in comparison of the magnetic moment component in the direction of the element length to the magnetic moment component in the direction of the element width in each domain, the total area of domains in which the component in the direction of the element length is larger than that in the direction of the element width is preferably equal to or larger than the total area of domains in which the component in the direction of the element width is larger than that in the direction of the element length.

In the magneto-impedance effect element comprising the magnetic field sensing portion having the above-described aspect ratio, when the external magnetic field is applied to the magnetic field sensing portion in the direction of the element length with the driving AC current supplied to the magnetic field sensing portion, the absolute value of the magnitude of the external magnetic field applied to produce the maximum output voltage between both ends of the magnetic field sensing portion is preferably 400 (A/m) or less.

The magneto-impedance effect element preferably further comprises a magnetic member for applying a bias magnetic field to the magnetic field sensing portion in parallel to the direction of the element length because the manufacturing process can be simplified, and miniaturization and power saving can be easily achieved.

The magnetic field sensing portion of the magneto-impedance effect element must comprise a ferromagnetic thin film or ribbon having soft magnetic properties. Also, the magnetic field sensing portion must have high magnetic permeability μ in the high frequency region of 1 MHz to several hundreds MHz. Furthermore, the magnetic field sensing portion preferably has low magnetostriction constant λ so as to prevent the magnetic properties from deteriorating due to the stress exerted on the soft magnetic thin film by an external magnetic field (the magnetic field component of airwaves).

In order to form the soft magnetic thin film comprising a thin film magnetic member having the above properties, the soft magnetic thin film is preferably formed as any one of the following fine crystalline soft magnetic alloy thin films.

1) Fine crystalline soft magnetic alloy thin films mainly comprising an amorphous structure and represented by the composition formula $Fe_h M_i O_j$; wherein M is at least one element selected from Ti, Hf, V, Nb, Ta, W, and the rare earth elements, and h, i, and j satisfy the relations $45 \leq h \leq 70$, $5 \leq i \leq 30$, $10 \leq j \leq 40$, and $h + i + j = 100$ .

Fe is an element for obtaining a high saturation magnetic flux density Bs, and M combines with O to increase resistivity ρ. With h, i, and j in the above ranges, a soft magnetic alloy having high saturation magnetic flux density Bs, resistivity ρ, and magnetic permeability μ can be obtained, while with h, i, and j out of the above ranges, the soft magnetic properties deteriorate.

Where element M in the above composition is at least one selected from the rare earth elements, h and j preferably satisfy the relations $50 \leq h \leq 70$ and $10 \leq j \leq 30$, respectively.

2) Fine crystalline soft magnetic alloy thin films represented by the composition formula $(Co_{1-c}T_c)_x M_y X_z O_w$; wherein element T is an element including either or both of Fe and Ni, element M is at least one element selected from Ti, Zr, Hf, V, Nb, Ta, Cr, Mo, Si, P, C, W, B, Al, Ga, Ge, and the rare earth elements, X is at least one element selected from Au, Ag, Cu, Ru, Rh, Os, Ir, Pt, and Pd, the composition ratio c satisfies $0 \leq c \leq 0.7$, and x, y, z, and w by atomic % satisfy the relations, $3 \leq y \leq 30$, $0 \leq z \leq 20$, $7 \leq w \leq 40$, and $20 \leq y + z + w \leq 60$, the balance comprising x.

The soft magnetic alloy preferably comprises a mixture of an amorphous phase containing a large amount of oxide of element M, and a fine crystalline phase mainly composed of Co and element T, the fine crystalline phase having a structure containing an oxide of element M.

3) Fine crystalline soft magnetic alloy thin films represented by the composition formula $T_{100-d-e-f-g}X_d$-$M_eX_fQ_g$ and mainly comprising crystal grains of at least one of bcc-Fe, bcc-FeCo, and bcc-Co; wherein element T is an element including either or both of Fe and Co, element X is an element including either of both of Si and Al, element M is at least one element selected from Ti, Zr, Hf, V, Nb, Ta, Mo, and W, element Z is an element including either or both of C and N, Q is at least one element selected from Cr, Re, Ru, Rh, Ni, Pd, Pt, and Au, and d, e, f, and g by at% satisfy the relations $0 \leq d \leq 25$, $1 \leq e \leq 10$, $0.5 \leq f \leq 15$, and $0 \leq g \leq 10$, respectively.

With d, e, f and g in the above ranges, a soft magnetic alloy thin film having high magnetic permeability $\mu$, and low coercive force Hc and magnetostriction constant $\lambda$ can be obtained.

4) Fine crystalline soft magnetic alloy thin films represented by the composition formula $T_{100-p-q-e-f-g}Si_p$-$Al_qM_eZ_fQ_g$ and mainly comprising crystal grains of at least one of bcc-Fe, bcc-FeCo, and bcc-Co; wherein element T is an element including either or both of Fe and Co, element M is at least one element selected from Ti, Zr, Hf, V, Nb, Ta, Mo, and W, element Z is an element including either or both of C and N, Q is at least one element selected from Cr, Re, Ru, Rh, Ni, Pd, Pt, and Au, and p, q, e, f, and g by at% satisfy the relations $8 \leq p \leq 15$, $0 \leq q \leq 10$, $1 \leq e \leq 10$, $0.5 \leq f \leq 15$, and $0 \leq g \leq 10$, respectively.

With p, q, e, f and g in the above ranges, a soft magnetic alloy thin film having high magnetic permeability $\mu$, and low coercive force Hc and magnetostriction constant $\lambda$ can be obtained.

The magnetic field sensing portion may comprise any one of the following amorphous soft magnetic alloy thin films or ribbons.

5) Amorphous soft magnetic alloy thin films or ribbons represented by the composition formula $(Fe_{1-a}Co_a)_{100-x-y}(Si_{1-b}B_b)_xM_y$; wherein M is an element including either or both of Cr and Ru, composition ratios a and b satisfy the relations $0.05 \leq a \leq 0.1$ and $0.2 \leq b \leq 0.8$, and x and y by at% satisfy the relations $10 \leq x \leq 35$ and $0 \leq y \leq 7$, respectively.

In the $(Fe_{1-a}Co_a)_{100-x-y}(Si_{1-b}B_b)_xM_y$ system soft magnetic alloy thin films or ribbons, the ratio a out of the range of $0.05 \leq a \leq 0.1$ is undesirable because the magnetostriction is increased. Also, the ratio b out of the range of $0.2 \leq b \leq 0.8$ is undesirable because it is difficult to form an amorphous phase. Furthermore, the ratio x of $x > 35$ is undesirable because the magnetic properties deteriorate.

6) Amorphous soft magnetic alloy thin films represented by the composition formula $Co_lTa_mHf_n$ and mainly comprising an amorphous structure; wherein composition ratios l, m and n by at% satisfy the relations $70 \leq l \leq 90$, $5 \leq m \leq 21$, $6.6 \leq n \leq 15$, and $1 \leq m/n \leq 2.5$.

In the $Co_lTa_mHf_n$ system soft magnetic alloy thin films, the saturation magnetic flux density Bs depends upon the Co content, and the relation $70 \leq 1$ is required for obtaining a high saturation magnetic flux density Bs. However, with $1 > 90$, the resistivity $\rho$ is undesirably decreased.

Ta and Hf are elements for obtaining soft magnetic properties. With $5 \leq m \leq 21$ and $6.6 \leq n \leq 15$, a soft magnetic material having a high saturation magnetic flux density Bs and low resistivity $\rho$ can be obtained. Hf is an element for resolving a negative magnetostriction constant $\lambda$ produced in a Co-Ta system. The magnetostriction constant $\lambda$ depends upon the ratio of the Ta content to the Hf content. With the m/n ratio in the range of $1 \leq m/n \leq 2.5$, the magnetostriction constant $\lambda$ can be efficiently resolved.

7) Amorphous soft magnetic alloy thin films represented by the composition formula $Co_aZr_bNb_c$ and mainly comprising an amorphous structure; wherein composition ratios a, b and c by at% satisfy the relations $78 \leq a \leq 91$ and $0.5 \leq b/c \leq 0.8$.

The saturation magnetic flux density Bs depends upon the Co content, and the relation $78 \leq a \leq 91$ is required for increasing Bs. With $a > 91$, corrosion resistance deteriorates, and the amorphous structure is not easily formed due to the start of crystallization. With $a < 78$, the ratio of adjacent Co elements is undesirably decreased to fail to exhibit the soft magnetic properties. The magnetic permeability $\mu$ also depends upon the Co content, and a high value is obtained in the range of $78 \leq a \leq 91$.

The method of manufacturing the magneto-impedance effect element comprises the following steps:

(a) The step of depositing a soft magnetic thin film on a substrate made of a nonmagnetic material in a static magnetic field in a predetermined direction; and

(b) The step of patterning the soft magnetic thin film with the ratio (aspect ratio) W/L of the element width W to the element length L set so that the direction of the static magnetic field applied in the step (a) coincides with the direction of the element width, and when an external magnetic field is applied to the magnetic field sensing portion of the magneto-impedance effect element in the direction of the element length with a driving AC current supplied thereto after the magneto-impedance effect element is formed, the absolute value of the magnitude of the external magnetic field producing the maximum output voltage between both ends of the magnetic field sensing portion is 400 (A/m) or less.

In the manufacturing method above, the magnetic field sensing portion is formed in the static magnetic field in the step (a), and in the step (b), the magnetic field sensing portion is patterned to substantially balance the magnetic anisotropy due to the shape of the magnetic field sensing portion, which is produced in the direction of the element length of the magnetic field sensing portion, with the magnetic anisotropy in the direction of the element width.

Where the aspect ratio of the soft magnetic thin film, which constitutes the magnetic field sensing portion, is set so that the absolute value of the magnitude of the external magnetic field producing the maximum output voltage between both ends of the magnetic field sensing portion is 400 (A/m) or less, the number of turns of a coil wound around the magnetic field sensing portion in order to apply a bias magnetic field to the magnetic field sensing portion can be decreased to simplify the process for manufacturing the magneto-impedance effect element. Also, miniaturization required for applying the magneto-impedance effect element to a magnetic head or a weak magnetic field sensor can easily be achieved. Furthermore, the DC current supplied to the coil for producing the bias magnetic field can be decreased to easily achieve power saving of the magneto-impedance effect element.

When the absolute value of the magnitude of the external magnetic field producing the maximum output voltage between both ends of the magnetic field sensing portion is 400 (A/m) or less, a magnetic field produced from a magnetic member comprising a magnetic material formed in the periphery of the magneto-impedance effect element or laminated thereon can be used as the bias magnetic field.

The manufacturing method preferably further comprises the following step (c) after the step (b):

> (c) The step of heat-treating the soft magnetic thin film patterned in the step (b) in a static magnetic field in the direction of the element width of the magnetic field sensing portion, a rotating magnetic field, or no magnetic field. This is preferable because the magnetic anisotropy due to the shape of the magnetic field sensing portion, which is produced in the direction of the element length thereof, can easily substantially be balanced with the magnetic anisotropy in the direction of the element width.

In a further aspect of the present invention, the method of manufacturing a magneto-impedance effect element comprises the following steps:

> (d) The step of depositing a soft magnetic thin film on a substrate made of a nonmagnetic material in a static magnetic field in a predetermined direction;
> (e) The step of heat-treating the soft magnetic thin film formed in the step (d) in a static magnetic field in the same direction as the static magnetic field applied in the step (d) with respect to the magnetic field sensing portion, a rotating magnetic field, or no magnetic field; and

(f) The step of patterning the soft magnetic thin film with the ratio (aspect ratio) W/L of the element width W to the element length L set so that the direction of the static magnetic field applied in the step (d) and/or (e) coincides with the direction of the element width, and when an external magnetic field is applied to the magnetic field sensing portion of the magneto-impedance effect element in the direction of the element length with a driving AC current supplied thereto after the magneto-impedance effect element is formed, the absolute value of the magnitude of the external magnetic field producing the maximum output voltage between both ends of the magnetic field sensing portion is 400 (A/m) or less.

The manufacturing method comprises depositing the soft magnetic thin film in a static magnetic field, pattering the soft magnetic thin film, and then heat-treating the soft magnetic thin film in a static magnetic field, a rotating magnetic field, or no magnetic field. However, the soft magnetic thin film may be heat-treated in a static magnetic field, a rotating magnetic field, or no magnetic field immediately after the deposition in a static magnetic field, and then patterned. Even in this case, the magnetic anisotropy due to the shape of the magnetic field sensing portion, which is produced in the direction of the element length of the magnetic field sensing portion can easily substantially be balanced with the magnetic anisotropy in the direction of the element width.

In the deposition in a static magnetic field in the step (a) or (d), and the heat treatment in a static magnetic field, a rotating magnetic field, or no magnetic field in the step (c) or (e), the magnetic anisotropy due to the shape of the magnetic field sensing portion, which is produced in the direction of the element length of the magnetic field sensing portion, is substantially balanced with the magnetic anisotropy in the direction of the element width to put the direction of magnetic anisotropy of the magnetic field sensing portion into a substantially isotropic state as a whole.

The deposition and heat treatment in magnetic field are performed for maintaining the high magnetic permeability of the magnetic field sensing portion even when the aspect ratio W/L is decreased, not only for providing the soft magnetic thin film with magnetic anisotropy in the direction of the element width.

In the step (a) or (d), the strength of the static magnetic field is preferably set to 800 (A/m) or more, more preferably 4800 (A/m) or more.

In the step (b) or (f), the aspect ratio of the magnetic field sensing portion is preferably set to 0.1 or less.

By forming the magnetic field sensing portion having the ratio (aspect ratio) W/L of element width W to element length L of 0.1 or less, the magneto-impedance effect element having improved magnetic field sensitivity can be produced.

In a further aspect of the present invention, the method of manufacturing a magneto-impedance effect element comprises the following steps:

(g) The step of forming a soft magnetic ribbon by contact quenching in which an alloy melt of a soft magnetic material is discharged on a cooling roll;

(h) The step of cutting the soft magnetic ribbon formed in the step (g) and patterning the cut soft magnetic ribbon with the ratio (aspect ratio) W/L of element width W to element length L set so that when an external magnetic field is applied to the magnetic field sensing portion of the magneto-impedance effect element in the direction of the element length with a driving AC current supplied thereto after the magneto-impedance effect element is formed, the absolute value of the magnitude of the external magnetic field producing the maximum output voltage between both ends of the magnetic field sensing portion is 400 (A/m) or less.

(i) The step of bonding the soft magnetic ribbon formed in the step (h) to a substrate; and

(j) The step of heat-treating the soft magnetic thin film in a static magnetic field in the direction of the element width.

In this way, the magnetic field sensing portion may be formed by using a soft magnetic ribbon formed from an alloy melt of a soft magnetic material.

In the step (h), the aspect ratio of the soft magnetic ribbon is preferably set to 0.1 or less.

In order to form the magnetic field sensing portion of the magneto-impedance effect element, which comprises a ferromagnetic thin film having soft magnetic properties such as high magnetic permeability μ in the high frequency region of 1 MHz to several hundreds MHz, and low magnetostriction constant λ, in the step (a) or (d), the soft magnetic thin film preferably has any one of the above-described compositions.

Embodiments of the invention will now be described, by way of example only, with reference to the accompanying drawings, in which:

Fig. 1 is a perspective view of a magneto-impedance effect element in accordance with an embodiment of the present invention;

Fig. 2 is a graph showing the relation between the aspect ratio and magnetic field sensitivity of a magnetic field sensing portion of a magneto-impedance effect element;

Fig. 3 is a graph showing the relation between the aspect ratio of a magnetic field sensing portion of a magneto-impedance effect element and the absolute value Hp of the magnitude of an external magnetic field producing the maximum output voltage Emi between both ends of the magnetic field sensing portion;

Fig. 4 is a conceptual diagram showing the magneto-impedance effect property of a magneto-impedance effect element in accordance with an embodiment of the present invention;

Fig. 5 is a conceptual plan view showing the domain structure of a magnetic field sensing portion of a conventional magneto-impedance effect element;

Fig. 6 is a conceptual plan view showing the domain structure of a magnetic field sensing portion of a magneto-impedance effect element of the present invention;

Fig. 7 is a conceptual plan view showing the domain structure of a magnetic field sensing portion of a magneto-impedance effect element of the present invention;

Fig. 8 is a sectional view illustrating a magneto-impedance effect element comprising a hard magnetic layer for applying a bias magnetic field in accordance with another embodiment of the present invention;

Fig. 9 is a sectional view illustrating a magneto-impedance effect element comprising a hard magnetic layer for applying a bias magnetic field in accordance with a further embodiment of the present invention;

Fig. 10 is a sectional view illustrating a magneto-impedance effect element comprising a antiferromagnetic layer for applying a bias magnetic field in accordance with a still further embodiment of the present invention;

Fig. 11 is a perspective view showing a state in which a soft magnetic thin film for forming a magnetic field sensing portion is deposited by using a soft magnetic material on a substrate made of a nonmagnetic material such as alumina titanium carbide;

Fig. 12 is a perspective view showing a state in which the soft magnetic thin film shown in Fig. 11 is patterned by photolithography and etching to form magnetic field sensing portions;

Fig. 13 is a perspective view showing a state in which electrodes are formed at both ends of each of the magnetic field sensing portions shown in Fig. 12;

Fig. 14 is a perspective view showing a liquid rapid cooling apparatus for forming a soft magnetic ribbon;

Fig. 15 is a drawing showing the photographic pattern of a magnetic field sensing portion of a magneto-impedance effect element of the present invention, which was observed by a Kerr effect polarization microscope;

Fig. 16 is a drawing showing the photographic pattern of a magnetic field sensing portion of a magneto-impedance effect element of the present invention, which was observed by a Kerr effect polarization microscope;

Fig. 17 is a drawing showing the photographic pattern of a magnetic field sensing portion of a magneto-impedance effect element of the present invention, which was observed by a Kerr effect polarization microscope;

Fig. 18 is a drawing showing the photographic pattern of a magnetic field sensing portion of a conventional magneto-impedance effect element, which was observed by a Kerr effect polarization microscope;

Fig. 19 is a graph showing the measured values of the magneto-impedance effect property of a magneto-impedance effect element of the present invention and a conventional magneto-impedance effect element;

Fig. 20 is a graph showing the measured values of the magneto-impedance effect property of a magneto-impedance effect element of the present invention and a conventional magneto-impedance effect element;

Fig. 21 is a graph showing the relation between the aspect ratio and the amount of change in output of a magnetic field sensing portion of a magneto-impedance effect element;

Fig. 22 is a conceptual diagram showing the method of applying an external magnetic field to a magneto-impedance effect element with a driving AC current supplied thereto;

Fig. 23 is a graph showing the magneto-impedance effect property of a conventional magneto-impedance effect element; and

Fig. 24 is a conceptual diagram showing the method of applying a bias magnetic field to a magneto-impedance effect element.

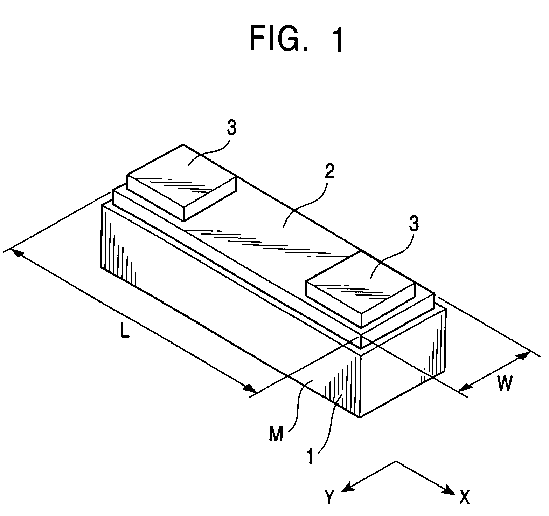

Fig. 1 is a perspective view of a magneto-impedance effect element in accordance with an embodiment of the present invention. The magneto-impedance effect element M shown in Fig. 1 comprises a substrate 1 made of a nonmagnetic material such as alumina titanium carbide, a magnetic field sensing portion 2 comprising a thin film of a soft magnetic material formed on the substrate 1 by sputtering or vapor deposition, and electrodes 3 comprising a conductive material such as Cu and formed at both ends of the magnetic field sensing portion 2 in the direction of the element length (X direction). The magnetic field sensing portion 2 is patterned in a substantially rectangular or linear shape. The magnetic field sensing portion 2 may be formed in a U shape or zigzag shape.

The magnetic field sensing portion 2 comprises a fine crystalline soft magnetic alloy thin film having a crystal grain diameter of 5 to 30 nm, represented by the composition formula $Fe_{71.4}Al_{5.8}Si_{13.1}Hf_{3.3}C_{4.5}Ru_{1.9}$ (at%), and mainly comprising bcc-Fe crystal grains, HfC crystal grains being present around the bcc-Fe crystal grains.

Besides this composition, soft magnetic alloy thin films which can be used for forming the magnetic field sensing portion 2 include fine crystalline soft magnetic alloy thin films having a T-X-M-Z-Q system (element T is an element including either or both of Fe and Co, element X is an element including either or both of Si and Al, element M is at least one element selected from Ti, Zr, Hf, V, Nb, Ta, Mo, and W, element Z is an element including either or both of C and N, and Q is at least one element selected from Cr, Re, Ru, Rh, Ni, Pd, Pt, and Au) composition; fine crystalline soft magnetic alloy thin films having a Co-T-M-X-O system (element T is an element including either or both of Fe and Ni, element M is at least one element selected from Ti, Zr, Hf, V, Nb, Ta, Cr, Mo, Si, P, C, W, B, Al, Ga, Ge, and the rare earth elements, and X is at least one element selected from Au, Ag, Cu, Ru, Rh, Os, Ir, Pt, and Pd) composition and comprising a crystalline phase of bcc-Fe, bcc-FeCo or bcc-Co having a crystal grain diameter of 10 to 30 nm and an amorphous phase containing an oxide of M with an amorphous phase ratio of 50% or more of the entire structure; and fine crystalline soft magnetic alloy thin films having a Fe-M-O system (element M is at least one element selected from Ti, Zr, Hf, V, Nb, Ta, W, and the rare earth elements) composition and comprising a crystalline phase mainly composed of bcc-Fe having a crystal grain diameter of 10 to 30 nm and an amorphous phase containing an oxide of M with an amorphous phase ratio of 50% or more of the entire structure.

The magnetic field sensing portion 2 may comprise a Fe-Co-Si-B-M system (M is an element including either or both of Cr and Ru) amorphous soft magnetic alloy thin film, a Co-Ta-Hf system amorphous soft magnetic alloy thin film, or a Co-Zr-Nb system amorphous soft magnetic alloy thin film.

A driving AC current is supplied to the magneto-impedance effect element M in the direction (X direction) of the element length from the electrodes 3 to excite the magnetic field sensing portion 2 in the direction (Y direction) of the element width. In this state, an external magnetic field Hex is applied in the direction of the element length to change the impedance of the magnetic field sensing portion 2. The change in impedance of the magnetic field sensing portion 2 is taken out as a change in voltage between the electrodes 3. The direction of the element length coincides with the direction perpendicular to the excitation direction of a magnetic field produced by the driving AC current.

In the U-shaped or zigzag-shaped magnetic field sensing portion 2, the direction of the element length is the extension direction of the longest portion of the magnetic field sensing portion 2, which coincides with the direction perpendicular to the excitation direction of the magnetic field produced by the driving AC current.

In the magneto-impedance effect element M, the ratio W/L (aspect ratio) of the element width W to the element length L of the magnetic field sensing portion 2 is set to 0.1 or less.

In the U-shaped or zigzag-shaped magnetic field sensing portion 2, the element length L is the total length of portions of the magnetic field sensing portion 2, which extend in the direction of the element length.

In this embodiment, the magnetic field sensing portion 2 has an element width W of 0.10 mm, and an element length L of 6 mm. Also, the magnetic field sensing portion 2 of the magneto-impedance effect element M has an aspect ratio W/L = 0.017.

When the magnetic field sensing portion 2 of the magneto-impedance effect element 2 comprises a soft magnetic thin film, a plurality of magnetic field sensing portions 2 can be simultaneously formed in thin films on a substrate, thereby obtaining the effect of significantly improving the productivity of elements. However, the magnetic field sensing portion 2 may comprise a ribbon formed by a single roll method or the like.

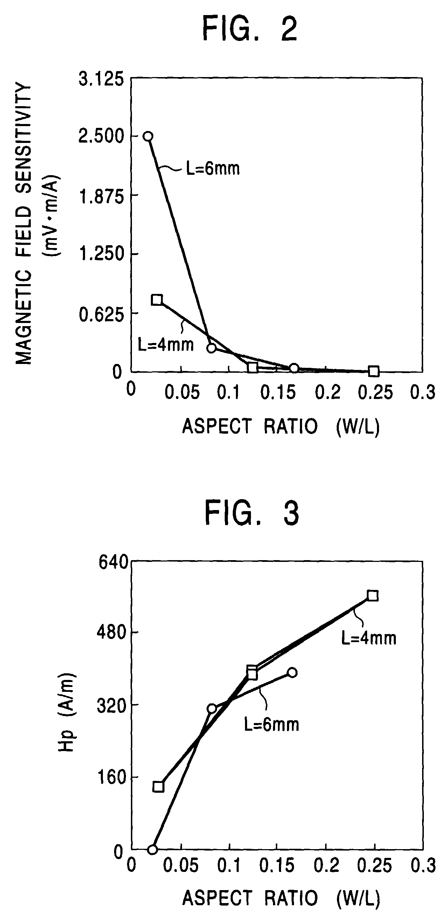

Fig. 2 is a graph showing the relation between the aspect ratio and magnetic field sensitivity of a magnetic field sensing portion of a magneto-impedance effect element. In the graph of Fig. 2, the element length of the magnetic field sensing portion is fixed at 4 mm or 6 mm, while the element width W is changed to change the aspect ratio W/L of the magnetic field sensing portion. Fig. 2 indicates that with the aspect ratio W/L of the magnetic field sensing portion of 0.1 or less, the magnetic field sensitivity of the magneto-impedance effect element is improved. Particularly, with the element length L of the magnetic field element of 6 mm, and the aspect ratio W/L of the magnetic field sensing portion of 0.08 or less, the magnetic field sensitivity of the magneto-impedance effect element is abruptly improved.

Fig. 2 also shows that since the magneto-impedance effect element M of this embodiment shown in Fig. 1 has an element length 6 mm and an aspect ratio of 0.017, the magneto-impedance effect element M has sensitivity of as high as about 2.5 (mV • m/A) (about 200 (mV/Oe)).

Fig. 3 is a graph showing the relation between the aspect ratio (W/L) of a magnetic field sensing portion of a magneto-impedance effect element and the absolute value (Hp) of the magnitude of an external magnetic field producing the maximum output voltage between both ends of the magnetic field sensing portion.

The graph of Fig. 3 indicates that the absolute value (Hp) of the magnitude of an external magnetic field producing the maximum output voltage between both ends of the magnetic field sensing portion decreases as the aspect ratio (W/L) of a magnetic field sensing portion of a magneto-impedance effect element decreases. In the graph of Fig. 3, the element length of the magnetic field sensing portion is fixed at 4 mm or 6 mm, while the element width is changed to change the aspect ratio of the magnetic field sensing portion.

For example, in the magnetic field sensing portion having an element length of 6 mm, with an aspect ratio (W/L) of about 0.1 or less, the absolute value (Hp) of the magnitude of the external magnetic field producing the maximum output voltage between both ends of the magnetic field sensing portion is 320 (A/m) (4 (Oe)) or less. Also, in the magnetic field sensing portion having an element length of 4 mm, with an aspect ratio (W/L) of about 0.1 or less, the absolute value (Hp) of the magnitude of the external magnetic field producing the maximum output voltage is 320 (A/m) (4 (Oe)) or less.

In the magnetic field sensing portion having an element length of 6 mm, with an aspect ratio (W/L) of about 0.05 or less, the absolute value (Hp) of the magnitude of the external magnetic field producing the maximum output voltage is 160 (A/m) (2 (Oe)).

The graph of Fig. 3 indicates that since the magnetic field sensing portion 2 of the magneto-impedance effect element M of the embodiment shown in Fig. 1 has an element length of 6 mm and an aspect ratio of 0.017, the absolute value (Hp) of the magnitude of the external magnetic field producing the maximum output voltage is in the range of about 0 to 24 (A/m) (0.3 (Oe)).

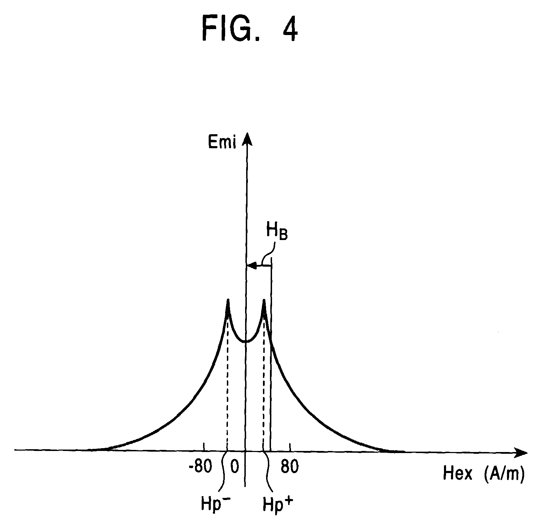

Fig. 4 is a conceptual diagram illustrating the magneto-impedance effect property of the magneto-impedance effect element of this embodiment.

In the state in which a driving AC current is supplied to the magnetic field sensing portion 2 of the magneto-impedance effect element M of this embodiment from the electrodes 3, an external magnetic field Hex is applied in the direction of the element length of the magneto-impedance effect element M. The output voltage Emi is measured with changing magnitudes of the external magnetic field Hex applied to obtain such a graph as Fig. 4.

The conceptual diagram of Fig. 4 showing the magneto-impedance effect property shows a bimodal shape having peaks of the output voltage Emi with the external magnetic fields Hex of magnitudes $Hp_+$ and $Hp_-$. The absolute values of the magnitudes $Hp_+$ and $Hp_-$ are substantially the same of about 0 to 24 (A/m) (0.3 (Oe)).

In Fig. 4, the rate of change in the output voltage Emi increases as the magnitude of the external magnetic field Hex approaches $Hp_+$ or $Hp_-$. Namely, the magnetic field sensitivity of the external magnetic field Hex is high with the external magnetic field of magnitude close to $Hp_+$ or $Hp_-$.

When the absolute value of the magnitude $Hp_+$ or $Hp_-$ is about 0 to 24 (A/m) (0.3 (Oe)), the magnitude of the bias magnetic field applied to the magnetic field sensing portion in the direction of the element length is, for example, $H_B$ = 0 to 80 (A/m) (1 (Oe)) which is sufficient for improving the magnetic field sensitivity of the external magnetic field Hex with the external magnetic field of near zero. Graphs of the magneto-impedance effect property of a magneto-impedance effect element based on measured values will be described below with reference to embodiments.

When the absolute value of magnitude Hp₊ or Hp₋ is 400 (A/m) (5 Oe)) or less, preferably 320 (A/m) (4 Oe)) or less, more preferably 160 (A/m) (2 Oe)) or less, the magnitude of the bias magnetic field applied to the magnetic field sensing portion 2 in the direction of the element length can be set to 400 (A/m) (5 Oe)) or less, preferably 320 (A/m) (4 Oe)) or less, more preferably 160 (A/m) (2 Oe)) or less.

When the magnitude of the bias magnetic field applied to the magnetic field sensing portion 2 in the direction of the element length can be set to 400 or less, a magnetic field produced from a magnetic film comprising a hard magnetic material formed in the periphery of the magnetic field sensing portion 2 or a hard magnetic material or an antiferromagnetic material laminated on the magnetic field sensing portion 2 can be used as the bias magnetic field.

When the magnitude of the bias magnetic field applied to the magnetic field sensing portion 2 in the direction of the element length can be set to 400 (A/m) (5 Oe)) or less, preferably 320 (A/m) (4 Oe)) or less, more preferably 160 (A/m) (2 Oe)) or less, the number of the tuns of a coil wound around the magnetic field sensing portion 2 in order to apply the bias magnetic field to the magnetic field sensing portion 2 is decreased, thereby simplifying the process for manufacturing the magneto-impedance effect element. Also, miniaturization necessary for applying the magneto-impedance effect element M to a magnetic head or a weak magnetic field sensor can easily be achieved. Furthermore, the DC current supplied to the coil to produce the bias magnetic field can be decreased, thereby easily achieving power saving of the magneto-impedance effect element.

By decreasing the ratio (aspect ratio) W/L of the element width W to the element length L of the magnetic field sensing portion of the magneto-impedance effect element, the effect of improving the magnetic field sensitivity of the magneto-impedance effect element is obtained from the following cause:

Since the magnetic field sensing portion is excited by a high-frequency AC current, the strong skin effect is exhibited. At this time, the element width W, the element length L, resistivity ρ, excitation frequency ω and magnetic permeability μ in the direction of the element width have the relation to the magnitude |Z| of impedance of the magnetic field sensing portion represented by the following equation (2).

$$|Z| = \left(\frac{L\sqrt{\rho\omega}}{2W}\right)\sqrt{\mu} \qquad \text{Equation 2}$$

Equation 2 indicates that with the element width W, the element length L, resistivity ρ, and excitation frequency ω of the magnetic field sensing portion kept constant, the magnitude |Z| of the impedance of the magnetic field sensing portion is proportional to the one second power of magnetic permeability μ in the direction of the element width.

When the external magnetic field is applied to the magnetic field sensing portion in the direction of the element length with the AC current supplied to the magnetic field sensing portion in the direction of the element length to excite it in the direction of the element width, the magnetic permeability μ of the magnetic field sensing portion in the direction of the element width is changed to change the magnitude |Z| of the impedance of the magnetic field sensing portion. The change in the magnitude |Z| of the impedance of the magnetic field sensing portion is measured to detect the external magnetic field applied to the magnetic field sensing portion.

The rate of change in the magnitude |Z| of the impedance with changes in the magnetic permeability μ in the direction of the element width increases as the aspect ratio W/L decreases. Namely, the change in magnitude of the output voltage produced between both ends of the magnetic field sensing portion is increased to improve the magnetic field sensitivity of the magneto-impedance effect element.

When the external magnetic field Hex is applied to the magnetic field sensing portion 2 with the driving AC current supplied thereto, the effect of decreasing the absolute value Hp of the magnitude of the external magnetic field Hex producing the maximum output voltage Emi from the magnetic field sensing portion 2 is obtained due to the fact that the magnetic field sensing portion has a magnetic domain structure comprising a mixture of domains with the magnetic moment oriented in the direction of the element length and domains with the magnetic moment oriented in the direction of the element width.

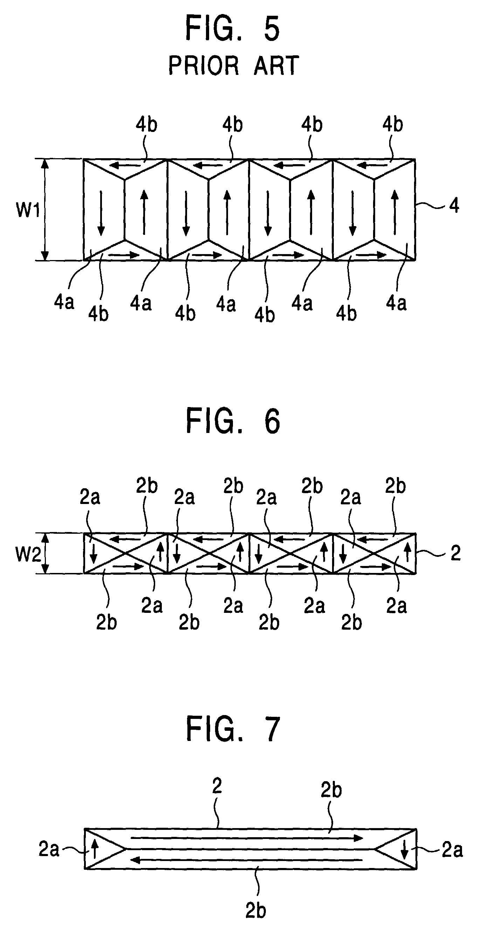

Fig. 5 is a conceptual plan view showing the magnetic domain structure of a magnetic field sensing portion of a conventional magneto-impedance effect element.

The magnetic field sensing portion 4 of the conventional magneto-impedance effect element shown in Fig. 5 is formed in a static magnetic field or by using a soft magnetic material with high anisotropy to maintain magnetic anisotropy in the direction of the element width. Therefore, magnetic domains 4a are formed, in which the magnetic moment is oriented in the direction of the element width. In Fig. 5, the element width of the magnetic field sensing portion 4 is denoted by W1.

On the other hand, magnetic domains 4b are also formed, in which the magnetic moment is oriented in the direction of the element length of the magnetic field sensing portion 4 due to the magnetic anisotropy resulting from the shape of the magnetic field sensing portion 4.

In the magnetic field sensing portion 4 having a high aspect ratio as in a conventional magneto-impedance effect element, the total area of the magnetic domains 4b in which the magnetic moment is oriented in the direction of the element length is significantly smaller than the total area of the magnetic domains 4a in which the magnetic moment is oriented in the direction of the element width.

Fig. 6 is a conceptual plan view showing the magnetic domain structure of the magnetic field sensing portion 2 of the magneto-impedance effect element M of the present invention.

For example, the element width of the magnetic field sensing portion 2 is set to W2 less than W1 so that the aspect ratio of the magnetic field sensing portion 2 is 0.1 or less.

In this embodiment, a soft magnetic thin film which constitutes the magnetic field sensing portion 2 has a multi-domain structure. In Fig. 6, magnetic domains 2b have a larger magnetic moment component in the direction of the element length as compared with a component in the direction of the element width, and magnetic domains 2a have a larger magnetic moment component in the direction of the element width as compared with a component in the direction of the element length. In Fig. 6, the total area of the magnetic domains 2b is substantially the same as the total area of the magnetic domains 4b shown in Fig. 5, and the total area of the magnetic domains 2a is smaller than the total area of the magnetic domains 4a shown in Fig. 5 so that the total area of the magnetic domains 2a is equal to the total area of the magnetic domains 2b. As a result, the direction of magnetic anisotropy of the magnetic field sensing portion 2 is brought into a substantially isotropic state as a whole.

When the total area of the magnetic domains 2b in which the component in the direction of the element length is larger than that in the direction of the element width is balanced with the total area of the magnetic domains 2a in which the component in the direction of the element width is larger than that in the direction of the element length, i.e., when the magnetic anisotropy energy in the direction of the element width is matched with that in the direction of the element length, the direction of the magnetic anisotropy of the magnetic field sensing portion 2 is put into a substantially isotropic state as a whole. Namely, the magnetic moment of the magnetic field sensing portion 2 is little fixed in one direction, and thus the direction of the magnetic moment is easily changed by exciting with the AC current. In other words, the magnetic permeability μ of the magnetic field sensing portion 2 in the direction of the element width is improved.

In the magnetic field sensing portion 2 exhibiting the maximum magnetic permeability in the direction of the element width, the magnitude Z of the impedance of the magnetic field sensing portion 2 becomes maximum, and the output voltage produced between both ends of the magnetic field sensing portion 2 also becomes maximum.

With no external magnetic field applied, the direction of the magnetic anisotropy of the magnetic field sensing portion 2 is brought into a state close to the isotropic state as a whole.

Therefore, even with no external magnetic field Hex applied to the magnetic field sensing portion 2 in the direction of the element length, or only a small external magnetic field Hex applied, the direction of the magnetic anisotropy of the magnetic field sensing portion 2 can be brought into the substantially isotropic state as a whole to maximize the magnetic permeability μ of the magnetic field sensing portion 2 in the direction of the element width, and to maximize the output voltage Emi produced between both ends of the magnetic field sensing portion 2.

Namely, when the external magnetic field Hex is applied to the magnetic field sensing portion 2 with the driving AC current supplied thereto, the absolute value Hp of the magnitude of the external magnetic field Hex producing the maximum output voltage Emi from the magnetic field sensing portion 2 can be decreased.

The magnetic field sensing portion 2 may have a single domain structure in which the magnetic moment component in the direction of the element length is balanced with that in the direction of the element width.

Even when the total area of the domains 2b in which the component in the direction of the element length is larger than that in the direction of the element width is larger than the total area of the domains 2a in which the component in the direction of the element width is larger than that in the direction of the element length, as shown in Fig. 7, the direction of the magnetic anisotropy of the magnetic field sensing portion 2 can be brought into a state close to the isotropic state as a whole, thereby obtaining the same degree of magnetic field sensitivity as a magneto-impedance effect element having a magnetic domain structure in which the total area of the magnetic domains 2b is balanced with the total area of the magnetic domains 2a.

In the magneto-impedance effect element of this embodiment, the magnetic field sensitivity can be improved to the range of 0.3 (mV • m/A) (25 mV/Oe) or more which permits practical use as at least a magnetic field sensor.

Also, the absolute value of the magnitude of the external magnetic field producing the maximum output voltage between both ends of the magnetic field sensing portion 2 can be decreased.

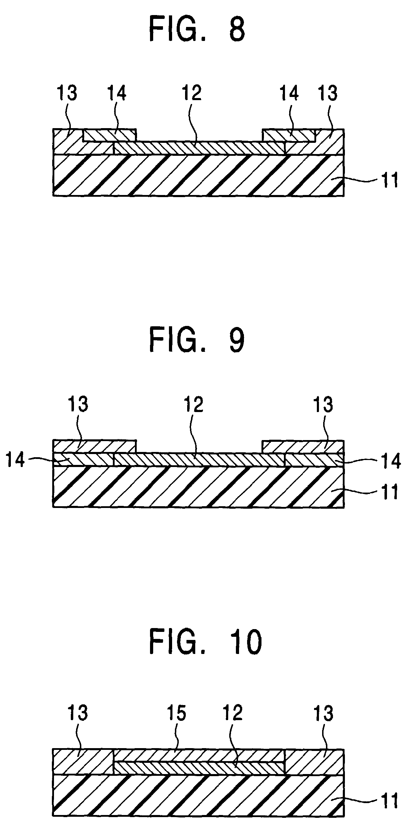

Figs. 8 to 10 are longitudinal sectional views respectively showing magneto-impedance effect elements in which the bias magnetic field can be applied by using a thin film magnetic member.

The magneto-impedance effect element shown in Fig. 8 comprises a magnetic field sensing portion 12 comprising a soft magnetic thin film formed on a substrate 11, electrodes 13 formed at both ends of the magnetic field sensing portion 12 in the direction of the element length, and hard magnetic layers 14 comprising magnetic thin films provided in contact with both ends of the magnetic field sensing portion 12. Each of the hard magnetic layers 14 is made of a hard magnetic material such as CoPt or the like.

Although the hard magnetic layers 14 can apply a bias magnetic field of magnitude of about 400 A/m at most, the hard magnetic layers 14 shown in Fig. 8 can apply a sufficient bias magnetic field to the magnetic field sensing portion 12 because the magnitude of the necessary bias magnetic field applied to the magnetic field sensing portion 2 in the direction of the element length in the magneto-impedance effect element of the present invention can be decreased to 400 (A/m) or less. Namely, a wound coil through which a DC current is passed in order to apply the bias magnetic field need not be used, and thus miniaturization and power saving of the magneto-impedance effect element can be achieved.

As shown in Fig. 9, the hard magnetic layers 14 may be formed on both sides of the magnetic field sensing portion in the direction of the element length so that the electrodes 13 are respectively formed on the hard magnetic layers 14.

Alternatively, as shown in Fig. 10, an antiferromagnetic layer 15 may be deposited on the magnetic field sensing portion 12 so that the necessary bias magnetic field is applied to the magnetic field sensing portion 12 by using an exchange anisotropic magnetic field produced at the interface between the magnetic field sensing portion 12 and the antiferromagnetic layer 15.

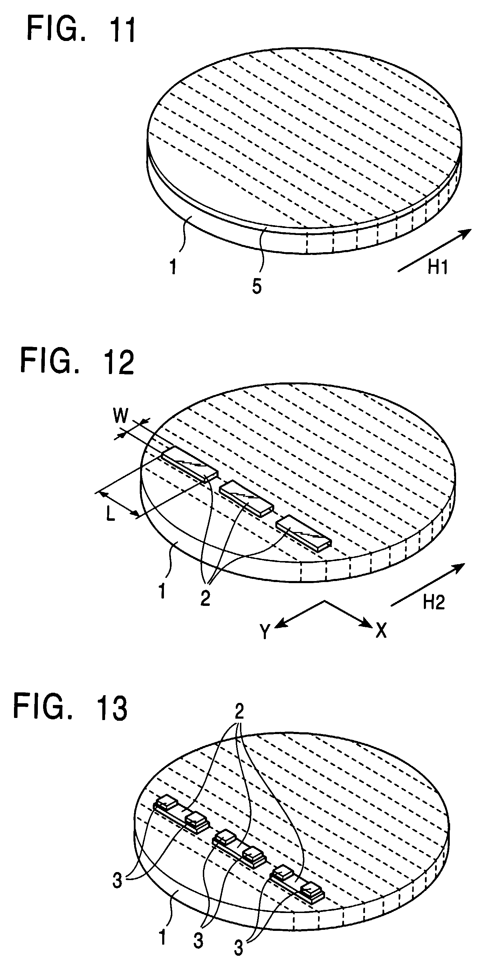

Figs. 11 to 13 are perspective views illustrating the method of manufacturing the magneto-impedance effect element shown in Fig. 1.

Fig. 11 is a perspective view illustrating a state in which a soft magnetic thin film 5 for forming the magnetic field sensing portion 2 is deposited on a substrate 1 made of a nonmagnetic material such as alumina titanium carbide (Al$_2$O$_3$-TiC), glass, ceramic, crystallized glass, SiO$_2$, or the like by sputtering, vapor deposition or plating using a soft magnetic material.

In depositing the soft magnetic thin film 5, a static magnetic field H1 is applied in the direction of an arrow shown in Fig. 11, which coincides with the direction of the element width of the completed magneto-impedance effect element shown in Fig. 1, so that the magnetic anisotropic energy due to the shape of the magnetic field sensing portion in the direction of the element length is balanced with the magnetic anisotropic energy in the direction of the element width.

The soft magnetic thin film 5 comprises, for example, a fine crystalline soft magnetic alloy thin film represented by the composition formula Fe$_{71.4}$Al$_{5.8}$Si$_{13.1}$Hf$_{3.3}$C$_{4.5}$Ru$_{1.9}$ and mainly comprising bcc-Fe crystal grains.

Besides this composition, soft magnetic alloy thin films which can be used for forming the soft magnetic thin film 5 include T-X-M-Z-Q system (element T is an element including either or both of Fe and Co, element X is an element including either or both of Si and Al, element M is at least one element selected from Ti, Zr, Hf, V, Nb, Ta, Mo, and W, element Z is an element including either or both of C and N, and Q is at least one element selected from Cr, Re, Ru, Rh, Ni, Pd, Pt, and Au) fine crystalline soft magnetic alloy thin films; fine crystalline soft magnetic alloy thin films having a Co-T-M-X-O system (element T is an element including either or both of Fe and Ni, element M is at least one element selected from Ti, Zr, Hf, V, Nb, Ta, Cr, Mo, Si, P, C, W, B, Al, Ga, Ge, and the rare earth elements, and X is at least one element selected from Au, Ag, Cu, Ru, Rh, Os, Ir, Pt, and Pd) composition and comprising a crystalline phase of bcc-Fe, bcc-FeCo or bcc-Co having a crystal grain diameter of 10 to 30 nm and an amorphous phase containing an oxide of M with an amorphous phase ratio of 50% or more of the entire structure; and fine crystalline soft magnetic alloy thin films having a Fe-M-O system (element M is at least one element selected from Ti, Zr, Hf, V, Nb, Ta, W, and the rare earth elements) composition and comprising a crystalline phase mainly composed of bcc-Fe having a crystal grain diameter of 10 to 30 nm and an amorphous phase containing an oxide of M with an amorphous phase ratio of 50% or more of the entire structure.

The soft magnetic thin film 5 may be formed as a Fe-Co-Si-B-M system (M is an element including either or both of Cr and Ru) amorphous soft magnetic alloy thin film, a Co-Ta-Hf system amorphous soft magnetic alloy thin film, or a Co-Zr-Nb system amorphous soft magnetic alloy thin film.

In this embodiment, the soft magnetic thin film 5 is deposited by using a RF magnetron sputtering apparatus. The deposition conditions are in the following ranges:

Radio frequency power: 200 to 400 (W)
Ar gas pressure: 50 (sccm)
Deposition pressure: 0.40 to 0.93 (Pa)
Strength of deposition static magnetic field; 800 (A/m) (10 or more (Oe))
Deposition rate: 10 to 33.5 (nm/min)

Standard conditions include a radio frequency power of 400 (W), an Ar gas pressure of 50 (sccm), a deposition pressure of 0.93 (Pa), a strength of deposition static magnetic field of 4800(A/m)(60(Oe)), and a deposition rate of 33.5 (nm/min). The substrate is cooled by direct cooling.

Next, the soft magnetic thin film 5 is patterned to form the magnetic field sensing portions 2 by photolithography and etching, as shown in Fig. 12. At this time, the soft magnetic thin film 5 is patterned so that each of the magnetic field sensing portions 2 has a substantially rectangular or linear shape having a ratio W/L (aspect ratio) of the element width W to the element length L of 0.1 or less.

The magnetic field sensing portion 2 may be formed in a U shape or zigzag shape by patterning. In the U-shaped or zigzag-shaped magnetic field sensing portion 2, the element length L equals to the total length of portions of the magnetic field sensing portion 2, which extends in the direction of the element length. In this case, the direction of the element length is the extension direction of the longest portion of the magnetic field sensing portion 2, which coincides with the direction perpendicular to the excitation direction of the magnetic field produced by the driving AC current.

The direction of the static magnetic field H1 shown in Fig. 11 coincides with the direction (Y direction) of the element width of the magnetic field sensing portion 2. In this embodiment, the magnetic field sensing portion 2 has an element width W of 0.10 mm, and an element length L of 6 mm. Therefore, the magnetic field sensing portion 2 of the magneto-impedance effect element M of this embodiment has an aspect ratio W/L = 0.017.

When an external magnetic field is applied to the magnetic field sensing portion 2 with the driving AC current supplied to thereto after the magneto-impedance effect element M is formed, the absolute value of the magnitude of the external magnetic field producing the maximum output voltage between both ends of the magnetic field sensing portion 2 is 400 (A/m) or less.

Although the magnetic field sensing portions 2 are formed over the surface of the substrate 1, Fig. 12 shows only some of the magnetic field sensing portions 2 formed.

The soft magnetic thin film 5 is deposited in the static magnetic field H1 so that the magnetic anisotropic energy in the direction (X direction) of the element length, which is due to the shape of the magnetic field sensing portion 2 formed by patterning the soft magnetic thin film 5, is substantially balanced with the magnetic anisotropic energy in the direction (Y direction) of the element width. Namely, the magnetic anisotropy in the direction (X direction) of the element length substantially is balanced with the magnetic anisotropy in the direction (Y direction) of the element width. As a result, each of the resultant magnetic field sensing portions 2 has a domain structure in which the total area of the magnetic domains 2b having the component in the direction of the element length larger than that in the direction of the element width, is equal to the total area of the magnetic domains 2a having a larger component in the direction of the element width, as shown in Fig. 6, or a domain structure in which the total area of the magnetic domains 2b having a component in the direction of the element length larger than that in the direction of the element width is larger than the total area of the magnetic domains 2a having a larger component in the direction of the element width, as shown in Fig. 7.

In this embodiment, after the magnetic field sensing portions 2 are formed by patterning, the magnetic field sensing portions 2 are further heat-treated with the static magnetic field H2 applied thereto in the direction of the element width. In this way, after the soft magnetic thin film 5 is deposited in a magnetic field, the magnetic field sensing portions 2 are heat-treated in the static magnetic field, rotating magnetic field or no magnetic field so that the magnetic anisotropy of each of the magnetic field sensing portions 2 in the direction (X direction) can easily substantially be balanced with the magnetic anisotropy thereof in the direction (Y direction) of the element width.

In this embodiment, the conditions of heat treatment in the static magnetic field, rotating magnetic field, or no magnetic field are in the following ranges:

Strength of static magnetic field: 0 to 80000 (A/m) (1 kOe)
Heat treatment temperature: 540 to 675 (°C)
Heat treatment time: 20 to 30 (min)
Heating rate: 10 to 14 (°C/min)

Standard conditions include a strength of static magnetic field of 80000 (A/m) (1 kOe), a heat treatment temperature of 575 (°C), a heat treatment time of 30 (min), and a heating rate of 13.6 (°C/min).

In this embodiment, as shown in Fig. 12, the magnetic field sensing portions 2 are formed by patterning and then heat-treated in the static magnetic field, rotating magnetic field or no magnetic field after the soft magnetic thin film is deposited in the magnetic field as shown in Fig. 11. However, heat treatment may be performed between the deposition of the soft magnetic thin film 5 and the formation of the magnetic field sensing portions 2 by patterning, i.e., in the state shown in Fig. 11, in which the static magnetic field in the same direction as the static magnetic field H1 applied in deposition of the soft magnetic thin film 5, the rotating magnetic field or no magnetic field is applied, followed by the formation of the magnetic field sensing portions 2 by patterning. The strength of the rotating magnetic field applied in heat treatment may be the same as the strength of the static magnetic field in heat treatment.

After the magnetic field sensing portions 2 are patterned and then heat-treated in the magnetic field, the electrodes 3 made of a conductive material such as Cu, Ni, Ti, Cr, or the like are formed at both ends of each of the magnetic field sensing portions 2 by sputtering, photolithography and etching, as shown in Fig. 13.

After the electrodes 3 are formed, the substrate 1 cut into such magneto-impedance effect elements M as shown in Fig. 1.

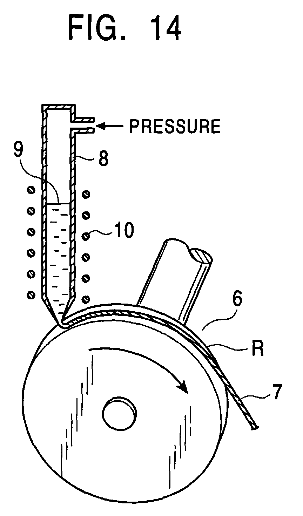

In forming the magnetic field sensing portion 2 comprising a soft magnetic ribbon, for example, the liquid quenching apparatus 6 shown in Fig. 14 is used.

A soft magnetic material is charged in a nozzle 8 made of quartz, and melted by heating with a heater 10 provided around the nozzle 8. The thus-melted alloy 9 is contact-cooled by a method in which pressure is applied to the upper portion of the nozzle 8 to eject the melted alloy 9 onto a cooling roll R rotating at a high speed, to form a soft magnetic ribbon 7.

The thus-obtained soft magnetic ribbon 7 is cut to form the substantially rectangular magnetic field sensing portion 2 in which the ratio (aspect ratio) W/L of the element width W to the element length L is 0.1 or less.

Next, the magnetic field sensing portion 2 is bonded to the substrate 1, and then heat-treated in the static magnetic field in the direction of the element width.

Furthermore, the electrodes 3 are formed at both ends of the magnetic field sensing portion 2 to obtain the magneto-impedance effect element shown in Fig. 1.

The magnetic field sensing portion 2 formed by the method of manufacturing the magneto-impedance effect element has the magnetic domain structure shown in Fig. 6 or 7.

Namely, the total area of the magnetic domains 2b in which the magnetic moment is oriented in the direction of the element length is close to the total area of the magnetic domains 2b in which the magnetic moment is oriented in the direction of the element width. In other words, the magnetic anisotropy of the magnetic field sensing portion 2 in the direction of the element length is substantially balanced with that in the direction of the element width.

Since the magneto-impedance effect element manufactured in this embodiment has an element length of 6 mm, and an aspect ratio of 0.017, it is found from the graph of Fig. 3 that the absolute value of the magnitude of the external magnetic field producing the maximum output voltage is about 24 (A/m) (about 0.3 (Oe)).

As in this embodiment, where the absolute value (Hp) of the magnitude of the external magnetic field producing the maximum output voltage Emi between both ends of the magnetic field sensing portion 2 is 400 (A/m) (5 (Oe)) or less, the number of the turns of the coil wound around the magnetic field sensing portion can be decreased, thereby simplifying the process for manufacturing the magneto-impedance effect element. Also, miniaturization necessary for applying the magneto-impedance effect element to a magnetic head or a weak magnetic field sensor can be easily achieved. In addition, the DC current supplied to the coil for producing the bias magnetic field can also be decreased to easily achieve power saving of the magneto-impedance effect element.

Furthermore, the magnetic field produced from a magnetic film comprising a magnetic material formed in the periphery of the magneto-impedance effect element or laminated on the magneto-impedance effect element can be used as the bias magnetic field.

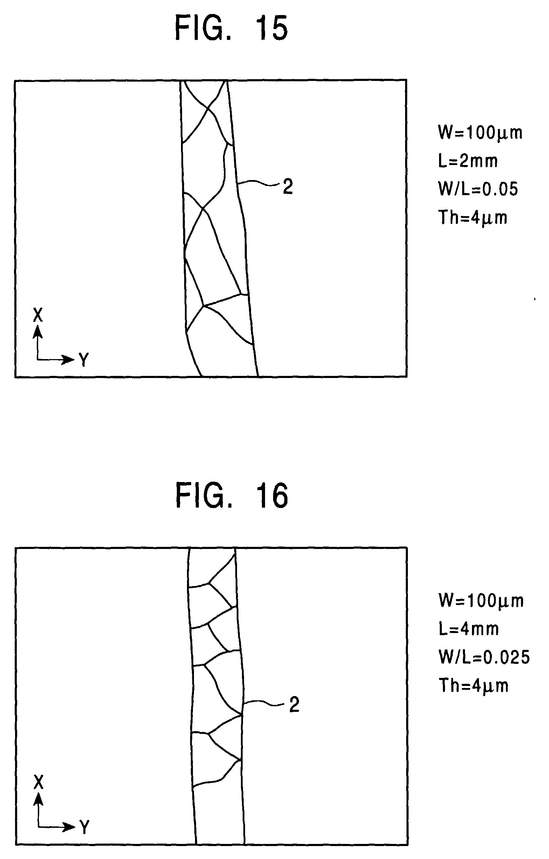

Figs. 15 to 17 are drawings each showing the photographic pattern of the magnetic field sensing portion 2 of the magneto-impedance effect element of the present invention, which was observed by a Kerr effect polarization microscope.

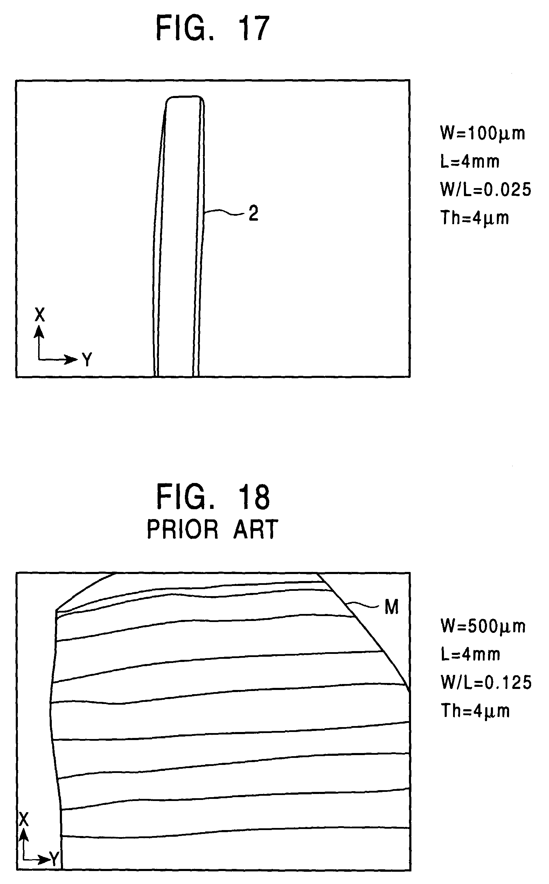

Fig. 15 shows the domain structure of the magnetic field sensing portion 2 in which the length in the direction (X direction) of the element length L = 2 mm, the length in the direction (Y direction) of the element width W = 100 μm, and an aspect ratio W/L = 0.05. Each of Figs. 16 and 17 shows the domain structure of the magnetic field sensing portion 2 in which the length in the direction (X direction) of the element length L = 4 mm, the length in the direction (Y direction) of the element width W = 100 μm, and an aspect ratio W/L = 0.025.

In Figs. 15 and 16, the total area of the magnetic domains with the magnetic moment oriented in the direction of the element width is balanced with the total area of the magnetic domains with the magnetic moment oriented in the direction of the element length, and the magnetic anisotropic energy in the direction of the element width is balanced with that in the direction of the element length, thereby bringing the direction of magnetic anisotropy into a substantially isotropic state as a whole.

In Fig. 17, the total area of the magnetic domains with the magnetic moment oriented in the direction of the element length is larger than the total area of the magnetic domains with the magnetic moment oriented in the direction of the element width, while the magnetic anisotropic energy in the direction of the element width is balanced with that in the direction of the element length, thereby bringing the direction of magnetic anisotropy into a substantially isotropic state as a whole.

In any of the magnetic field sensing portions 2 shown in Figs. 15 to 17, the magnetic moment is little fixed in a direction, and the direction of magnetic moment is easily changed at the time of excitation with the AC current. Namely, the magnetic permeability μ of the magnetic field sensing portion 2 in the direction of the element width is increased to increase the magnetic field sensitivity of the magneto-impedance effect element. The absolute value of the magnitude of the external magnetic field producing the maximum output voltage between both ends of the magnetic field sensing portion 2 can also be decreased to decrease the magnitude of the necessary bias magnetic field.

Fig. 18 is a diagram showing the photographic pattern of a magnetic field sensing portion of a conventional magneto-impedance effect element, which was observed by a Kerr effect polarization microscope.

Fig. 18 shows the domain structure of the magnetic field sensing portion in which the length in the direction (X direction) of the element length L = 4 mm, the length in the direction (Y direction) of the element width W = 500 μm, and an aspect ratio W/L = 0.125.

In Fig. 18, the domains with the magnetic moment oriented in the direction of the element width have a majority in the magnetic field sensing portion, and thus the direction of magnetic anisotropy is oriented in the direction of the element width.

Namely, the magnetic field sensing portion has low permeability $\mu$, and the magneto-impedance effect element has low magnetic field sensitivity. Also, the absolute value of the magnitude of the external magnetic field producing the maximum output voltage between both ends of the magnetic field sensing portion is high, thereby increasing the necessary bias magnetic field.

Any of the magnetic field sensing portions shown in Figs. 15 to 18 has the FeAlSiHfCRu system composition, and comprises a fine crystalline soft magnetic alloy thin film mainly comprising bcc-Fe crystal grains, and having a thickness of 4 $\mu$m.

Examples

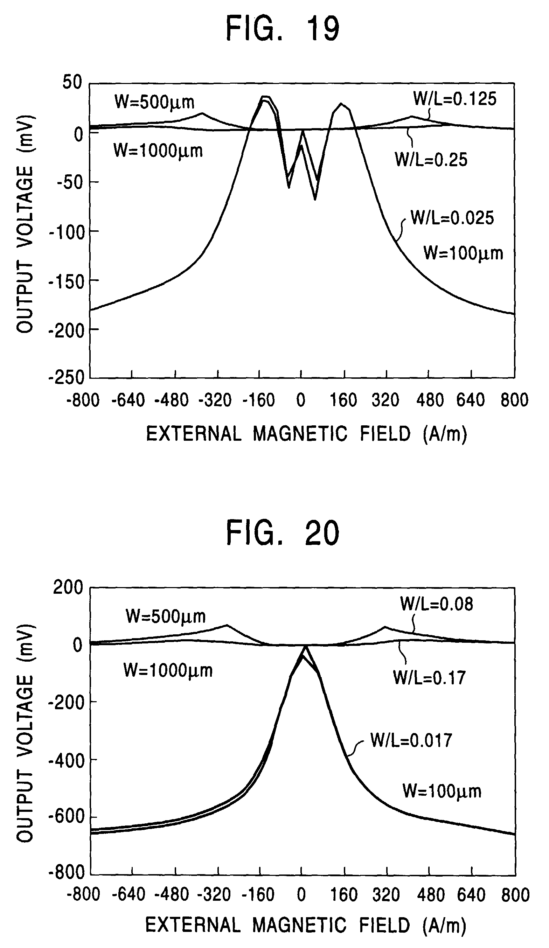

Figs. 19 and 20 are graphs showing the results of measurement of the magneto-impedance effect property by using the magneto-impedance effect element shown in Fig. 1.

In the magneto-impedance effect element M shown in Fig. 1, the external magnetic field Hex was applied to the magnetic field sensing portion 2 in the direction of the element length of the magneto-impedance effect element M with the driving AC current supplied to both ends of the magnetic field sensing portion 2 from the electrodes 3. The output voltage Emi was measured with changing external magnetic fields Hex applied.

Fig. 19 shows the results of the magnetic field sensing portion comprising a fine crystalline soft magnetic alloy thin film having the FeAlSiHfCRu system composition, and mainly comprising bcc-Fe crystal grains, having a length of 4 mm in the direction of the element length and a thickness of 4 $\mu$m, with changing lengths in the direction of the element width.

Fig. 19 indicates that in the magnetic field sensing portion 2 having a length of 1000 $\mu$m (W/L = 0.25) or 500 $\mu$m (W/L = 0.125) in the direction of the element width, the output voltage little changes with changes in the external magnetic fields, and thus the magnetic field sensing portion does not function as a magnetic field sensor. The absolute value of the magnitude of the external magnetic field producing the maximum output voltage exceeds 400 (A/m).

On the other hand, in the magnetic field sensing portion 2 having a length of 100 $\mu$m (W/L = 0.025) in the direction of the element width, the output voltage changes by 200 mV or more at most with changes in the external magnetic fields, and thus the magnetic field sensing portion functions as a magnetic field sensor. The absolute value of the magnitude of the external magnetic field producing the maximum output voltage 160 (A/m).

In the magnetic field sensing portion 2 having a length of 100 $\mu$m (W/L = 0.025) in the direction of the element width, the soft magnetic thin film which constitutes the magnetic field sensing portion 2 has a single domain structure or a multi-domain structure. In comparison between the magnetic moment component in the direction of the element length and the component in the direction of the element width in each of the domains, the total area of the domains having the component in the direction of the element length larger than that in the direction of the element width is equal to or larger than the total area of the domains having the component in the direction of the element width larger than that in the direction of the element length.

Fig. 20 shows the results of the magnetic field sensing portion having the FeAlSiHfCRu system composition, and comprising a fine crystalline soft magnetic alloy thin film mainly comprising bcc-Fe crystal grains, and having a length of 6 mm in the direction of the element length and a thickness of 4 $\mu$m, with changing lengths in the direction of the element width.

Fig. 20 indicates that in the magnetic field sensing portion 2 having a length of 1000 $\mu$m (W/L = 0.17) in the direction of the element width, the output voltage little changes with changes in the external magnetic fields, and thus the magnetic field sensing portion does not function as a magnetic field sensor. The absolute value of the magnitude of the external magnetic field producing the maximum output voltage exceeds 400 (A/m).

On the other hand, in the magnetic field sensing portion 2 having a length of 500 $\mu$m (W/L = 0.08) in the direction of the element width, the output voltage changes by 50 mV or more at most with changes in the external magnetic fields, and thus the magnetic field sensing portion functions as a magnetic field sensor. The absolute value of the magnitude of the external magnetic field producing the maximum output voltage is 320 (A/m). Furthermore, in the magnetic field sensing portion 2 having a length of 100 $\mu$m (W/L = 0.017) in the direction of the element width, the output voltage changes by 600 mV or more at most with changes in the external magnetic fields, and thus the magnetic field sensing portion functions as a magnetic field sensor having very high sensitivity. The absolute value of the magnitude of the external magnetic field producing the maximum output voltage 0 to 24 (A/m).

In the magnetic field sensing portion 2 having a length of 500 $\mu$m or 100 $\mu$m in the direction of the element width, the soft magnetic thin film which constitutes the magnetic field sensing portion 2 has a single domain structure or a multi-domain structure. In comparison between the magnetic moment component in the direction of the element length and the component in the direction of the element width in each of the domains, the total area of the domains with the component in the direction of the element length larger than that in the direction of the element width is equal to or larger than the total area of the domains with the component in the direction of the element width larger than that in the direction of the element length.

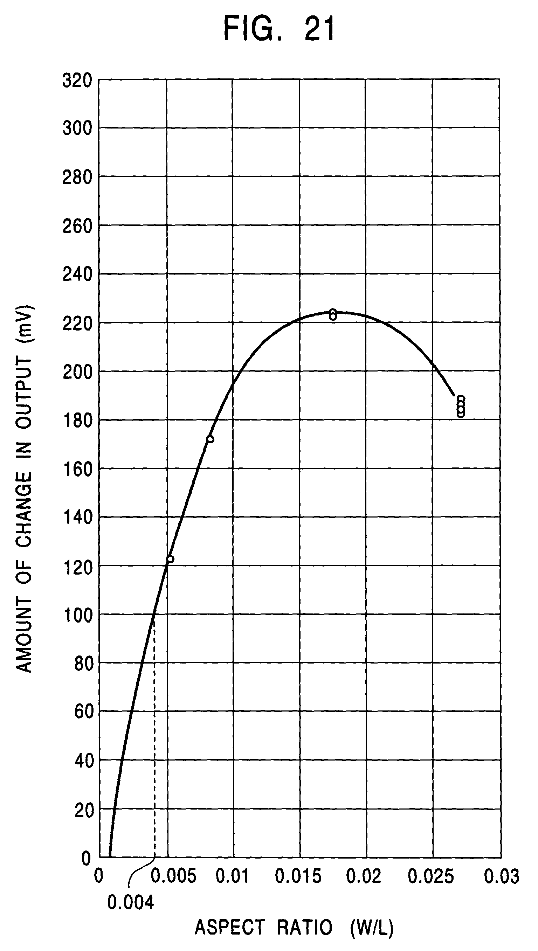

Fig. 21 is a graph showing the results of measurement of the relation between the aspect ratio of a magnetic field sensing portion and the amount of change in output voltage with an external magnetic field applied by using magneto-impedance effect elements having a constant length of 3 mm in the direction of the element length of the magnetic field sensing portion and various lengths in the direction of the element width.

In Fig. 12, the amount of change in output voltage represents the amount of change in voltage with a change in external magnetic field of 320 (A/m).

In use of the magneto-impedance effect element as a magnetic field sensor, the amount of change in output shown in the graph of Fig. 21 is preferably 100 mV or more. Therefore, the aspect ratio (W/l) of the magnetic field sensing portion is preferably 0.004 or more.

In Fig. 21, the aspect ratio of the magnetic field sensing portion producing the maximum change in output is 0.017.

As described above, the absolute value of the magnitude of the external magnetic field producing the maximum output voltage between both ends of the magnetic field sensing portion is 400 (A/m) (5 (Oe)) or less so that the number of the turns of a coil wound around the magnetic field sensing portion in order to apply a bias magnetic field to the magnetic field sensing portion can be decreased, thereby simplifying the process for manufacturing a magneto-impedance effect element. Also, miniaturization necessary for applying the magneto-impedance effect element to a magnetic head or a weak magnetic field sensor can easily be achieved. Furthermore, the DC current supplied to the coil for producing the bias magnetic field can decreased, thereby easily achieving power saving of the magneto-impedance effect element.

A decrease in the necessary bias magnetic field permits the magnetic field produced from a magnetic member comprising a magnetic material formed in the periphery of the magneto-impedance effect element or laminated thereof to be used as the bias magnetic field.

Furthermore, a soft magnetic thin film or ribbon which constitutes the magnetic field sensing portion has a single domain structure or a multi-domain structure in which in comparison between the magnetic moment component in the direction of the element length and the component in the direction of the element width in each of the domains, the total area of the domains with the component in the direction of the element length larger than that in the direction of the element width is equal to or larger than the total area of the domains with the component in the direction of the element width larger than that in the direction of the element length. Therefore, the direction of magnetic anisotropy of the soft magnetic thin film or ribbon which constitutes the magnetic field sensing portion can be brought into a state close to an isotropic state as a whole, and thus the absolute value of the magnitude of the external magnetic field producing the maximum output voltage between both ends of the magnetic field sensing portion can be decreased.

Furthermore, in forming the magnetic field sensing portion comprising a thin film or ribbon in the magneto-impedance effect element, the ratio (aspect ratio) W/L of the element width W to the element length L of the magnetic field sensing portion is set to 0.1 or less to improve the magnetic field sensitivity of the magneto-impedance effect element.

**Claims**

1. A magneto-impedance effect element comprising a magnetic field sensing portion comprising a soft magnetic thin film or ribbon having the magneto-impedance effect, and an electrode for supplying a driving AC current to the magnetic field sensing portion;
   wherein when an external magnetic field is applied to the magnetic field sensing portion in the direction of the element length with a driving AC current supplied to the magnetic field sensing portion, the absolute value of the magnitude of the external magnetic field producing the maximum output voltage between both ends of the magnetic field sensing portion is 400 (A/m) or less.

2. A magneto-impedance effect element according to Claim 1, wherein the absolute value of the magnitude of the external magnetic field producing the maximum output voltage between both ends of the magnetic field sensing portion is 320 (A/m) or less.

3. A magneto-impedance effect element according to Claim 1, wherein the absolute value of the magnitude of the external magnetic field producing the maximum output voltage between both ends of the magnetic field sensing portion is 160 (A/m) or less.

4. A magneto-impedance effect element according to Claim 1, 2 or 3, wherein the soft magnetic thin film or ribbon which constitutes the magnetic field sensing portion has a single domain structure or multi-domain structure, and in comparison between the magnetic moment component in the direction of the element length and the magnetic moment component in the direction of the element width in each of domains, the total area of domains in which a component in the direction of the element length is larger than that in the direction of the element width is equal to the total area of domains in which a component in the direction of the element width is larger than that in the direction of the element length.

5. A magneto-impedance effect element according to Claim 1, 2 or 3, wherein the soft magnetic thin film or ribbon which constitutes the magnetic field sensing portion has a single domain structure or multi-domain structure, and in comparison between the magnetic moment component in the direction of the element length and the magnetic moment component in the direction of the element width in each of domains, the total area of domains in which a component in the direction of the element length is larger than that in the direction of the element width is larger than the total area of domains in which a component in the direction of the element width is larger than that in the direction of the element length.

6. A the magneto-impedance effect element according to any preceding Claim, wherein the ratio (aspect ratio) W/L of the element width W to the element length L of the magnetic field sensing portion is 0.1 or less.

7. A magneto-impedance effect element comprising a magnetic field sensing portion comprising a soft magnetic thin film or ribbon having the magneto-impedance effect, and an electrode for supplying a driving AC current to the magnetic field sensing portion;
wherein the soft magnetic thin film or ribbon, which constitutes the magnetic field sensing portion, has a single domain structure or multi-domain structure, and in comparison of the magnetic moment component in the direction of the element length to the magnetic moment component in the direction of the element width in each domain, the total area of domains in which a component in the direction of the element length is larger than that in the direction of the element width is larger than or equal to the total area of domains in which a component in the direction of the element width is larger than that in the direction of the element length.

8. A magneto-impedance effect element according to Claim 7, wherein when an external magnetic field is applied to the magnetic field sensing portion in the direction of the element length with the driving AC current supplied to the magnetic field sensing portion, the absolute value of the magnitude of the external magnetic field producing the maximum output voltage between both ends of the magnetic field sensing portion is 400 (A/m) or less.

9. A magneto-impedance effect element according to Claim 7 or 8, wherein the ratio (aspect ratio) W/L of the element width W to the element length L of the magnetic field sensing portion is 0.1 or less.

10. A magneto-impedance effect element comprising a magnetic field sensing portion comprising a soft magnetic thin film or ribbon having the magneto-impedance effect, and an electrode for supplying a driving AC current to the magnetic field sensing portion, wherein the ratio (aspect ratio) W/L of the element width W to the element length L of the magnetic field sensing portion is 0.1 or less.

11. A magneto-impedance effect element according to Claim 10, wherein the ratio (aspect ratio) W/L of the element width W to the element length L of the magnetic field sensing portion is 0.05 or less.

12. A magneto-impedance effect element according to Claim 10, wherein the ratio (aspect ratio) W/L of the element width W to the element length L of the magnetic field sensing portion is 0.03 or less.

13. A magneto-impedance effect element according to Claim 10, 11 or 12, wherein the soft magnetic thin film or ribbon which constitutes the magnetic field sensing portion has a single domain structure or multi-domain structure, and in comparison between the magnetic moment component in the direction of the element length and the magnetic moment component in the direction of the element width in each of domains, the total area of domains in which a component in the direction of the element length is larger than that in the direction of the element width is equal to the total area of domains in which a component in the direction of the element width is larger than that in the direction of the element length.

14. A magneto-impedance effect element according to Claim 10, 11 or 12, wherein the soft magnetic thin film or ribbon which constitutes the magnetic field sensing portion has a single domain structure or multi-domain structure, and in comparison between the magnetic moment component in the direction of the element length and the magnetic moment component in the direction of the element width in each of domains, the total area of domains in which a component in the direction of the element length is larger than that in the direction of the element width is larger than the total area of domains in which a component in the direction of the element width is larger than that in the direction of the element length.

15. A magneto-impedance effect element according to any Claim 10 to 14, wherein when an external magnetic field is applied to the magnetic field sensing portion in the direction of the element length with the driving AC current supplied to the magnetic field sensing portion, the absolute value of the magnitude of the external magnetic field producing the maximum output voltage between both ends of the magnetic field sensing portion is 400 (A/m) or less.

16. A method of manufacturing a magneto-impedance effect element comprising:

(a) the step of depositing a soft magnetic thin film on a substrate made of a nonmagnetic material in a static magnetic field in a predetermined direction; and

(b) the step of patterning the soft magnetic thin film with the ratio (aspect ratio) W/L of the element width W to the element length L set so that the direction of the static magnetic field applied in the step (a) coincides with the direction of the element width, and when an external magnetic field is applied to the magnetic field sensing portion of the magneto-impedance effect element in the direction of the element length with a driving AC current supplied thereto after the magneto-impedance effect element is formed, the absolute value of the magnitude of the external magnetic field producing the maximum output voltage between both ends of the magnetic field sensing portion is 400 (A/m) or less.

17. A method of manufacturing a magneto-impedance effect element according to Claim 16, further comprising the following step (c) after the step (b):

(C) the step of heat-treating the soft magnetic thin film patterned in the step (b) in a static magnetic field in the direction of the element width of the magnetic field sensing portion, a rotating magnetic field, or no magnetic field.

18. A method of manufacturing a magneto-impedance effect element according to Claim 16 or 17, in the step (a), the strength of the static magnetic field is set to 800 (A/m) or more.

19. A method of manufacturing a magneto-impedance effect element according to any Claim 16 to 18, in the step (b), the aspect ratio of the magnetic field sensing portion is set to 0.1 or less.

20. A method of manufacturing a magneto-impedance effect element comprising:

(d) the step of depositing a soft magnetic thin film on a substrate made of a nonmagnetic material in a static magnetic field in a predetermined direction;

(e) the step of heat-treating the soft magnetic thin film formed in the step (d) in a static magnetic field in the same direction as the static magnetic field applied in the step (d) with respect to the magnetic field sensing portion, a rotating magnetic field, or no magnetic field; and

(f) the step of patterning the soft magnetic thin film with the ratio (aspect ratio) W/L of the element width W to the element length L set so that the direction of the static magnetic field applied in the step (d) and/or (e) coincides with the direction of the element width, and when an external magnetic field is applied to the magnetic field sensing portion of the magneto-impedance effect element in the direction of the element length with a driving AC current supplied thereto after the magneto-impedance effect element is formed, the absolute value of the magnitude of the external magnetic field producing the maximum output voltage between both ends of the magnetic field sensing portion is 400 (A/m) or less.

21. A method of manufacturing a magneto-impedance effect element according to Claim 20, wherein in the step (d), the strength of the static magnetic field is set to 800 (A/m) or more.

22. A method of manufacturing a magneto-impedance effect element according to Claim 20 or 21, wherein in the step (f), the ratio (aspect ratio) W/L of the element width W to the element length L of the magnetic field sensing portion is set to 0.1 or less.

# FIG. 1

# FIG. 2

# FIG. 3

# FIG. 4

# FIG. 5
## PRIOR ART

4b     4b     4b     4b

W1

4

4a   4b   4a   4b   4a   4b   4a   4b   4a

# FIG. 6

2a   2b   2a   2b   2a   2b   2a   2b

W2

2

2b   2a   2b   2a   2b   2a   2b   2a

# FIG. 7

2         2b

2a                2a

2b

# FIG. 8

# FIG. 9

# FIG. 10

FIG. 11

FIG. 12

FIG. 13

# FIG. 14

# FIG. 15

W=100μm
L=2mm
W/L=0.05
Th=4μm

# FIG. 16

W=100μm
L=4mm
W/L=0.025
Th=4μm

# FIG. 17

W=100μm
L=4mm
W/L=0.025
Th=4μm

# FIG. 18
## PRIOR ART

W=500μm
L=4mm
W/L=0.125
Th=4μm

# FIG. 19

# FIG. 20

# FIG. 21

# FIG. 22
## PRIOR ART

Emi

Hex

Mi

Iac

R

Eac

# FIG. 23
## PRIOR ART

Emi

$H_{B1}$

$H_{B2}$

$Hp^-$

0

$Hp^+$

Hex

# FIG. 24
## PRIOR ART